(19) Europäisches Patentamt
European Patent Office
Office européen des brevets

(11) EP 1 580 825 B1

# (12) EUROPEAN PATENT SPECIFICATION

(45) Date of publication and mention of the grant of the patent:
**11.06.2008 Bulletin 2008/24**

(51) Int Cl.:
***H01L 51/00*** *(2006.01)* ***G11C 13/02*** *(2006.01)*

(21) Application number: **05251695.2**

(22) Date of filing: **19.03.2005**

## (54) Memory devices based on electric field programmable films

Speicherbauelemente basierend auf elektrisch programmierbaren Filmen

Blocs de mémoires basés sur les films programmables de champ électrique

(84) Designated Contracting States:
**DE FR GB IT NL**

(30) Priority: **24.03.2004 US 556246 P**

(43) Date of publication of application:
**28.09.2005 Bulletin 2005/39**

(73) Proprietor: **ROHM AND HAAS COMPANY**
**Philadelphia,**
**Pennsylvania 19106-2399 (US)**

(72) Inventors:
- **Bu, Lujia**
  **Holden, Massachusetts 01520 (US)**
- **Cutler, Charlotte**
  **Waltham, Massachusetts 02453 (US)**
- **Szmanda, Charles R.**
  **Westborough, Massachusetts 01581 (US)**
- **Cagin, Emine**
  **Waltham, Massachusetts 02453 (US)**
- **Gronbeck, Dana A.**
  **Holliston, Massachusetts 01746 (US)**
- **Greer, Edward C.**
  **Lower Gwynedd, Pennsylvania 19002 (US)**

(74) Representative: **Buckley, Guy Julian et al**
**Rohm and Haas Europe Services ApS - UK Branch**
**European Patent Department**
**4th Floor, 22 Tudor Street**
**London EC4Y 0AY (GB)**

(56) References cited:
**US-A- 5 238 607** **US-B1- 6 208 553**

- **PATENT ABSTRACTS OF JAPAN vol. 010, no. 063 (C-332), 13 March 1986 (1986-03-13) & JP 60 203608 A (HITACHI KASEI KOGYO KK), 15 October 1985 (1985-10-15)**
- **TAYLOR D M ET AL: "Memory effect in the current-voltage characteristic of a low-band gap conjugated polymer" JOURNAL OF APPLIED PHYSICS, AMERICAN INSTITUTE OF PHYSICS. NEW YORK, US, vol. 90, no. 1, 1 July 2001 (2001-07-01), pages 306-309, XP012053463 ISSN: 0021-8979**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### BACKGROUND OF THE INVENTION

The present disclosure relates to electronic memory devices based on electric field programmable films.

Electronic memory and switching devices are presently made from inorganic materials such as crystalline silicon. Although these devices have been technically and commercially successful, they have a number of drawbacks, including complex architectures and high fabrication costs. In the case of volatile semiconductor memory devices, the circuitry must constantly be supplied with a current in order to maintain the stored information. This results in heating and high power consumption. Non-volatile semiconductor devices avoid this problem but have reduced data storage capability as a result of higher complexity in the circuit design, which consequently results in higher production costs.

Alternative electronic memory and switching devices employ a bistable element that can be converted between a high impedance state and a low impedance state by applying an electrical current or other type of input to the device. Both organic and inorganic thin-film semiconductor materials can be used in electronic memory and switching devices, for example thin films of amorphous chalcogenide semiconductor organic charge-transfer complexes such as copper-7,7,8,8-tetracyanoquinodimethane (Cu-TCNQ) thin films, and certain inorganic oxides in organic matrices. These materials have been proposed as potential candidates for nonvolatile memories.

A number of different architectures have been implemented for electronic memory and switching devices based on semiconducting materials. These architectures reflect a tendency towards specialization with regard to different tasks. For example, matrix addressing of memory location in a single plane such as a thin film is a simple and effective way of achieving a large number of accessible memory locations while utilizing a reasonable number of lines for electrical addressing. Thus, for a square grid having n lines in two given directions, the number of memory locations is $n^2$. This principle has been implemented in a number of solid-state semiconductor memories. In such systems, each memory location has a dedicated electronic circuit that communicates to the outside. Such communication is accomplished via the memory location, which is determined by the intersection of any two of the 2n lines. This intersection is generally referred to as a grid intersection point and may have a volatile or non-volatile memory element. The grid intersection point can further comprise an isolation device such as an isolation diode to enable addressing with reduced cross-talk between and among targeted and non targeted memory locations. Such grid intersection points have been detailed by G. Moore, Electronics, September 28, (1970), p. 56.

Several volatile and non volatile memory elements have been implemented at the grid intersection points using various bistable materials. However, many currently known bistable films are inhomogeneous, multilayered composite structures fabricated by evaporative methods, which are expensive and can be difficult to control. In addition, these bistable films do not afford the opportunity for fabricating films in topographies ranging from conformal to planar. Bistable films fabricated using polymer matrices and particulate matter are generally inhomogeneous and therefore unsuitable for fabricating submicrometer and nanometer-scale electronic memory and switching devices. Still other bistable films can be controllably manufactured by standard industrial methods, but their operation requires high temperature melting and annealing at the grid intersection points. Such films generally suffer from thermal management problems, have high power consumption requirements, and afford only a small degree of differentiation between the "conductive" and "nonconductive" states. Furthermore, because such films operate at high temperatures, it is difficult to design stacked device structures that allow high density memory storage.

Accordingly, there remains a need in the art for improved electric field programmable bistable films that are useful as subsystems in electronic memory and switching devices, wherein such films can be applied to a variety of substrates and produced with a variety of definable topographies. Further, there is a need for electronic memory and switching devices comprising electric field programmable bistable films that can be produced more easily and inexpensively than known devices, that offer more useful differentiation between low conductivity and high conductivity states, that have reduced power and thermal requirements and that can be stacked in various configurations to fabricate electronic devices of higher density.

### SUMMARY OF THE INVENTION

The present invention in its various aspects is as set out in the accompanying claims. Disclosed herein is an electric field programmable film comprising a polymer bonded to an electroactive moiety.

Disclosed herein too is an electric field programmable film comprising a crosslinked polymer having an electron donor and/or an electron acceptor and/or a donor-acceptor complex covalently bonded to the crosslinked polymer.

Disclosed herein too is an electric field programmable film comprising a polymer, wherein the polymer is a 9-anthracenemethyl methacrylate/2-hydroxyethyl methacrylatel3-(trimethoxysilyl)propyl methacrylate terpolymer, a quinolin-8-yl methacrylate/2-hydroxyethyl methacrylate copolymer, a 9-anthracenemethyl methacrylate/2-hydroxyethyl methacrylate copolymer, a quinolin-8-yl methacrylate/2-hydroxyethyl methacrylate/3-(trimethoxysilyl) propyl methacrylate terpolymer, a 9-anthracenemethyl methacrylate, a quinolin-8-yl methacrylate, or a combination comprising at least one of the foregoing polymers; and an electroactive moiety covalently bonded to the polymer, wherein the electroactive moiety comprises a naphthalene, an anthracene, a phenanthrene, a tetracene, a pentacene, a triphenylene, a triptycene, a fluorenone, a phthalocyanine, a tetrabenzoporphine, a 2-amino-1H-imidazole-4,5-dicarbonitrile, a carbazole, a ferrocene, a dibenzochalcophene, a phenothiazine, a tetrathiafulvalene, a bisaryl azo group, a coumarin, an acridine, a phenazine, a quinoline, an isoquinoline, a pentafluoroaniline, an anthraquinone, a tetracyanoanthraquinodimethane, a tetracyanoquinodimethane, or a combination comprising at least one of the foregoing electroactive moieties.

Disclosed herein too is a method of manufacturing an electric field programmable film comprising depositing upon a substrate, a composition comprising a polymer and an electroactive moiety that is covalently bonded to the polymer.

Disclosed herein too is a data processing machine comprising a processor for executing an instruction; and a memory device comprising an electric field programmable film, wherein the electric field programmable film comprises a polymer covalently bonded to an electroactive moiety, and further wherein the memory device is in electrical communication with the processor.

## DESCRIPTION OF FIGURES

Figure 1 depicts a schematic of an electric field programmable film;

Figure 2(a) depicts a cutaway view of a cross-point array data storage device with a continuous electric field programmable film;

Figure 2(b) depicts a cutaway view of a cross-point array data storage device with a plurality of pixelated electric field programmable film elements;

Figure 3(a) depicts a schematic diagram of a cross point array device comprising electric field programmable film elements;

Figure 3(b) depicts a schematic diagram of a cross point array device comprising electric field programmable film elements;

Figure 4 depicts a cutaway partially exploded view of a stacked data storage device on a substrate;

Figure 5 depicts a cutaway partially exploded view of a stacked data storage device on a substrate;

Figure 6 depicts a partially exploded cutaway view of another stacked data storage device comprising a substrate and three device layers; and

Figure 7 provides, in a cutaway, contiguous, 7(a), and exploded, 7(b), views of a portion of a data storage device in which the memory elements are isolated by junction diodes.

## DETAILED DESCRIPTION OF THE INVENTION

In one embodiment, the polymer that is used in the electric field programmable-film is bonded to either an electron donor and/or an electron acceptor and/or an electron donor-acceptor complex. In another embodiment, the polymer that is used in the electric field programmable film is crosslinkable and is bonded to either an electron donor and/or an electron acceptor and/or an optional electron donor-acceptor complex. The term crosslinkable means that the polymer chains have an average functionality of greater than 2 and can be bonded to one another if desired.

Polymers used in the electric field programmable film may have a dielectric constant of 2 to 1000. In one embodiment, the polymer has sufficient chemical and thermal resistance to withstand processes involving the deposition of metals, etch barrier layers, seed layers, metal precursors, photoresists and antireflective coatings. It is also desirable for the polymer to impart a low level of electrical conductivity to the electric field programmable film in the "off' state and to permit for a sufficiently high concentration of electron donors and electron acceptors to enable a sufficiently high conductivity in the "on" state so that the difference between the "off" state and the "on" state is readily discerned. Electrical conductivity of the polymer is less than or equal to about 10-12 $ohm^{-1}cm^{-1}$. It is desirable for the ratio of the electrical current in the "on" state to that in the "off" state to be greater than or equal to 5, with greater than or equal to 100 being an example, and greater than or equal to 500 being another example.

An on/off ratio greater than 5 allows the "on" and "off" states of an electric field programmable film to be discerned readily while an on/off ratio greater than 100 allows the "on" and "off" states to be discerned more readily and an on/off ratio greater than 500 allows the "on" and "off" states to be discerned most readily. On/off ratios may be engineered to meet the requirements of the device. For example, devices having high impedance sense amplifiers and requiring higher speed operation require larger on/off ratios, while in devices having lower speed requirements smaller on/off ratios are acceptable.

As stated above, polymers having dielectric constant of 2 to 1,000 can be used. The dielectric constant (denoted by $\kappa$) of the matrix material can be selected such that "on" and "off" switching voltages are engineered to conform to the specific requirements of the application. Within the aforementioned range, polymers having dielectric constants of less

than or equal to about 4 are an example, with less than or equal to about 6 being another example, and greater than about 6 being yet another example. Without intending to be bound by theory, it is believed that polymers with higher dielectric constants may be used to produce devices having lower switching voltages. However, polymers having higher dielectric constants may also respond to applied field stimuli more slowly. Nevertheless, device speed and switching voltages can be engineered to meet the needs of a particular application using polymers having various dielectric constants and other device parameters such as the thickness of the field programmable film and the area subtended by the top and bottom electrodes.

The polymers that may be used in electric field programmable films are oligomers, polymers, ionomers, dendrimers, copolymers such as block and random copolymers, graft copolymers, star block copolymers, or the like, or a combination comprising at least one of the foregoing polymers. As noted above, the polymers may be bonded to either an electron donor and/or an electron acceptor and/or an optional electron donor-acceptor complex. The electron donors, electron acceptors and the electron donor-acceptor complexes are collectively termed as "electroactive moieties"

??just a repeat??. Suitable examples of polymers that can be used in the electric field programmable film are polyacetals, polyacrylics, polycarbonates, polystyrenes, polyesters, polyamides, polyamideimides, polyarylates, polyarylsulfones, polyethersulfones, polyphenylene sulfides, polysulfones, polyimides, polyetherimides, polytetrafluoroethylenes, polyetherketones, polyether etherketones, polyether ketone ketones, polybenzoxazoles, polyoxadiazoles, polybenzothiazinophenothiazines, polybenzothiazoles, polypyrazinoquinoxalines, polypyromellitimides, polyquinoxalines, polybenzimidazoles, polyoxindoles, polyoxoisoindolines, polydioxoisoindolines, polytriazines, polypyridazines, polypiperazines, polypyridines, polypiperidines, polytriazoles, polypyrazoles, palycarboranes, polyoxabicyclononanes, polydibenzofurans, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfdes, polythioesters, polysulfones, polysulfonamides, polyureas, polybenzocyclobutenes, polyphosphazenes, polysilazanes, polysiloxanes, or the like, or combinations comprising at least one of the foregoing polymers.

Suitable examples of the copolymers that may be used in the electric field programmable film include copolyestercarbonates, acrylonitrile butadiene styrene, styrene acrylonitrile, polyimide-polysiloxane, polyester-polyetherimide, polymethylmethacrylate-polysiloxane, polyurethane-polysiloxane, or the like, or combinations comprising at least one of the foregoing polymers or copolymers. In one embodiment, the electron donors and/or the electron acceptors may be bonded to at least one segment of a block copolymer. Because of phase separation, the electron donors and/or electron acceptors may segregate into domains of the block to which they are covalently bonded.

Mixtures of polymers may also be used in the electric field programmable film. When mixtures of polymers are used, it may be desirable to mix a first polymer that is bonded to either an electron donor and/or an electron acceptor and/or an electron donor-acceptor complex with a second polymer. In one embodiment, the second polymer is a polymer that may or may not be covalently bonded to either an electron donor and/or an electron acceptor and/or an electron donor-acceptor complex. The first and/or the second polymer may be crosslinkable. Suitable examples of mixtures of polymers include acrylonitrile-butadiene-styrene/nylon, polycarbonatelacrylonitrile-butadiene-styrene, acrylonitrile butadiene styrene/polyvinyl chloride, polyphenylene ether/polystyrene, polyphenylene ether/nylon, polysulfone/acrylonitrile butadiene-styrene, polycarbonate/thermoplastic urethane, polycarbonate/polyethylene terephthalate, polycarbonate/polybutylene terephthalate, thermoplastic elastomer alloys, nylon/elastomers, polyester/elastomers, polyethylene terephthalate/polybutylene terephthalate, acetal/elastomer, styrene-maleicanhydride/acrylonitrile-butadiene-styrene, polyether etherketone/polyethersulfone, polyethylene/nylon, polyethylene/polyacetal, or the like, or combinations comprising at least one of the foregoing mixtures of polymers.

As noted above, the polymers may be bonded to either an electron donor and/or an electron acceptor and/or an optional electron donor-acceptor complex. Such bonding may be, for example, be covalent bonding or ionic bonding. In order to bond the electron donors and/or the electron acceptors and/or the donor-acceptor complexes to the polymer, the polymer is functionalized. These functional groups may also be used to crosslink the polymer. Suitable examples of functional groups that are covalently bonded to the backbone of the polymer and/or to a group that is covalently bonded to the electron acceptor and/or electron donors include bromo groups, chloro groups, iodo groups, fluoro groups, primary and secondary amino groups, hydroxyl groups, thio groups, phosphino groups, alkylthio groups, amido groups, carboxyl groups, aldehyde groups, ketone groups, lactone groups, lactam groups, carboxylic acid anhydride groups, carboxylic acid chloride groups, sulfonic acid groups, sulfonic acid chloride groups, phosphonic acid groups, phosphonic acid chloride groups, aryl groups, heterocyclyl groups, ferrocenyl groups, groups comprising $\eta^5$-cyclopentadienyl-M (M = Ti, Cr, Mn, Fe, Co, Ni, Zr, Mo, Tc, Ru, Rh, Ta, W, Re, Os, Ir), heteroaryl groups, alkyl groups, hydroxyalkyl groups, , alkoxysilyl groups, alkaryl groups, alk-hetero-aryl groups, aralkyl groups, heteroaralkyl groups, ester groups, carboxylic acid groups, alcohol groups, alcohol groups comprising primary, secondary and tertiary alcohols, fluoro-substituted carboxylic acid groups, 1,2-dicarboxylic acid groups, 1,3-dicarboxylic acid groups, 1,n-alkane-dicarboxylic acid groups, wherein n varies from 2 to 9; m,n-alkane-diol groups, wherein m is 1or 2 and wherein n varies in an amount of 2 to 9; 1,2-dicarboxylic acid ester groups; 1,3-dicarboxylic acid ester groups, vinyl groups, epoxy groups, n-hydroxy alkanoic acid groups, where n varies in an amount of 1 to m-1 and m varies in an amount of 2 to 9; aryl dicarboxylic acid groups

having 6 to 22 carbon atoms, heteroaryl dicarboxylic acid groups having 5 to 21 carbon atoms, aryl diol groups having 6 to 22 carbon atoms, heteroaryl diol groups having 5 to 21 carbon atoms, hydroxyaryl-carboxylic acid groups having 6 to 22 carbon atoms, hydroxy-heteroaryl-carboxylic acid groups having 5 to 21 carbon atoms, 1,2-dicarboxylic acid ester groups, 1,3-dicarboxylic acid ester groups, 1,n-alkane-dicarboxylic acid ester groups, wherein n varies in an amount of 2 to 9aryl dicarboxylic acid ester groups having 6 to 22 carbon atoms, heteroaryl dicarboxylic acid ester groups having 5 to 21 carbon atoms, hydroxyaryl-carboxylic acid ester groups having 6 to 22 carbon atoms, hydroxy-heteroaryl-carboxylic acid ester groups having 5 to 21 carbon atoms, or the like, or a combination comprising at least one of the foregoing.

For example, polymer comprising (meth)acrylic repeat units may have bound electroactive moieties attached to the polymer chain as esters in pendant fashion. This may be generally accomplished by polymerizing 9-anthracenemethyl methacrylate which has a bound electroactive moiety(e.g., the 9-anthracene methanol group). In an exemplary embodiment, this monomer can also be polymerized and/or copolymerized with other monomers having unsaturated groups such as ($C_1$-$C_{7;}$ linear or branched) alkyl (meth)acrylate, ($C_1$-$C_{7;}$ linear or branched) hydroxyalkyl (meth)acrylate, ($C_1$-$C_{8;}$ linear or branched) alkoxyalkyl (meth)acrylate, ($C_1$-$C_{8;}$ linear or branched) cyanoalkyl (meth)acrylate, ($C_1$-$C_{7;}$ linear or branched) haloalkyl (meth)acrylate, ($C_1$-$C_{7;}$ linear or branched) perfluoroalkyl-methyl-(meth)acrylate, a tri-($C_1$-$C_{7;}$ linear or branched) alkoxysilyl ($C_1$-$C_7$, linear or branched) alkyl (meth)acrylate such as 3-(trimethoxysilyl)-propyl methacrylate, ($C_6$-$C_{22}$) aryl (meth)acrylate, ($C_1$-$C_{7;}$ linear or branched )alkyl-($C_6$-$C_{22}$)aryl (meth)acrylate, ($C_5$-$C_{21}$) heteroaryl (meth)acrylate, ($C_1$-$C_{7;}$ linear or branched)a]kyl-($C_5$-$C_{21}$)heteroaryl (meth)acrylate, or the like. Alternatively, 9-anthracenemethyl methacrylate or 9-anthracenemethyl acrylate can be copolymerized with other monomers having sites of unsaturation such as styrenic monomers, examples of which are styrene, 2,3 or 4 acetoxystyrene, 2,3 or 4 hydroxy styrene, 2,3 or 4 ($C_1$ - $C_6$) alkyl styrene, 2,3 or 4 ($C_1$-$C_6$)alkoxy styrene or the like.

Other electroactive moieties may suitably be incorporated as pendant groups on (meth)acrylic monomers. These include ($C_{10}$-$C_{22}$) fused ring aryl (meth)acrylates, ($C_1$-$C_7$; linear or branched)alkyl($C_{10}$-$C_{22}$) fused ring aryl (meth) acrylates, ($C_9$-$C_{21}$) fused ring heteroaryl (meth)acrylates, ($C_1$-$C_7$; linear or branched)alkyl($C_9$-$C_{21}$) fused ring heteroaryl (meth)acrylates, metallocenyl (meth)lacrylates such as ferrocenyl methacrylate, and tetrathiafulvalene-yl-methyl-(meth) acrylate and its selenium and tellurium analogs.

Monomers comprising unsaturated groups bound directly to the electroactive moiety can be polymerized and/or copolymerized with other monomers having unsaturated groups such as ($C_1$-$C_{7;}$ linear or branched) alkyl (meth)acrylate, ($C_1$-$C_7$; linear or branched) hydroxyalkyl (meth)acrylate, ($C_1$-$C_{8;}$ linear or branched) alkoxyalkyl (meth)acrylate, ($C_1$-$C_{8.}$ linear or branched) cyanoalkyl (meth)acrylate, ($C_1$-$C_{7;}$ linear or branched) haloalkyl (meth)acrylate, ($C_1$-$C_{7;}$ linear or branched) perfluoroalkyl-methyl-(meth)acrylate, a tri-($C_1C_7$; linear or branched) alkoxysilyl ($C_1$-$C_{7;}$ linear or branched) alkyl (meth)acrylate such as 3-(trimethoxysilyl)-propyl methacrylate, ($C_6$-$C_{22}$), glycidyl (meth)acrylate, aryl (meth)acrylate, ($C_1$-$C_{7;}$ linear or branched )alkyl-($C_6$-$C_{22}$)aryl (meth)acrylate, ($C_5$-$C_{21}$)heteroaryl (meth)acrylate, ($C_1$-$C_7$; linear or branched)alkyl-($C_5$-$C_{21}$)heteroaryl (meth)acrylate or the like.

Alternatively or in addition, vinyl substituted electroactive moieties can be copolymerized with other monomers having sites of unsaturation such as styrenic monomers exemplified by styrene, 2,3 or 4 acetoxystyrene, 2,3 or 4 hydroxy styrene, 2,3 or 4 alkyl ($C_1$-$C_6$) styrene, 2,3 or 4 alkoxy ($C_1$-$C_6$) styrene or the like. Vinyl-substituted electroactive moieties such as vinyl substituted fused-ring aryl or fused-ring heteroaryl monomers, N-vinyl substituted heteroaryl monomers, vinyl metallocene monomers such as vinyl ferrocene, vinyltetrathiafulvalene, or the like, can be copolymerized with at least one of the forgoing monomers to produce suitable polymers. It may be desirable to remove the acetoxy group on acetoxy esters after polymerization in order to provide a site for crosslinking.

Other polymers may also be used to incorporate electroactive moieties within the polymer chain such as, for example, polyesters, polyamides, polyimides, and the like. In this case, the electroactive moiety is a monomer that is difunctional and undergoes polymerization with monomers having a complementary chemistry. For example, an electroactive moiety having at least two carboxylic acid or carboxylic acid chloride groups can react suitably with a diol monomer to form a polyester. Alternatively, an electroactive moiety having at least two hydroxyl (-OH) groups can be made to react with a dicarboxylic acid monomer or a dicarboxylic acid anhydride monomer to form a different polyester. Further, an electroactive moiety having at least one -OH group and at least one carboxylic acid group may suitably homopolymerize or copolymerize with another monomer having an -OH group and a carboxylic acid group, or a lactone monomer. The substitution on the electroactive moiety is governed in part by the manner in which the reacting substituents affect the electronic structure of the electroactive moiety in the resulting polymer.

Suitable linkages formed from combinations of the foregoing groups comprise esters, amides, imides, thioesters, ethers, thioethers, formals, acetals, ketals, products of Friedel-Crafts reactions and the like. The following are examples of suitable electron donors and electron acceptors, along with exemplary chemical moieties for bonding them to the polymer.

Suitable examples of electroactive moieties are shown below along with substitution schemes for bonding them covalently to the polymer. In addition, an indication of whether the electroactive moiety is capable of acting as an electron donor (D), an electron acceptor (A) or is capable of acting as either a donor and/or an acceptor (D/A) is also given, based on computed values of the ionization energy and electron affinity in the semi-empirical PM3 molecular orbital approximation.

Substituted pyrene moieties can be covalently bonded to a polymer according to the following structures (I) and (II):

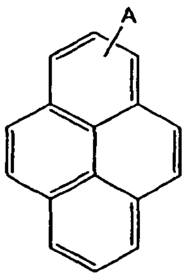

I

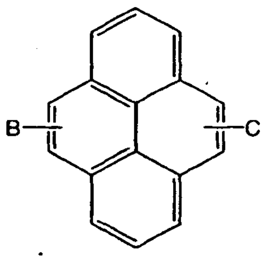

II

wherein in structure (I), A can be vinyl, methylol(-$CH_2OH$), hydroxy, primary amine, secondary amine, carboxylic acid, carboxylic acid chloride, or sulfonic acid. The vinyl group bonds the pyrene moiety covalently to the polymer by incorporating the vinyl group into the backbone of the polymer. The methylol, hydroxy, primary amine and secondary amine, groups bond the pyrene moiety covalently to the polymer as a pendant group. A suitable example of such a bonding can occur in a (meth)acrylate monomer group. The carboxylic acid, carboxylic acid chloride, and sulfonic acid groups bond the pyrene moiety covalently to the polymer as a pendant group such as might be demonstrated in a vinyl alcohol carboxylic acid ester or a vinyl alcohol sulfonic acid ester.

In structure (II) above, B and C can be the same or different and can be a hydrogen, vinyl, methylol(-$CH_2OH$), hydroxy, primary amine, secondary amine, carboxylic acid, carboxylic acid chloride, or sulfonic acid. In the case where both B and C are vinyl, the vinyl group B can be covalently bonded to the backbone of a first polymer while the second vinyl group C can be covalently bonded to the backbone of a second polymer in such a manner so as to facilitate crosslinking of the polymers. When B is a vinyl and C is either a metbylol(-$CH_2OM$), hydroxy, primary amine or secondary amine, the vinyl group can bond the pyrene moiety covalently to the polymer while the methylol, hydroxy, primary amine or secondary amine groups are available for crosslinking by an aminoplast resin, a glycidyl isocyanurate resin such as triglycidyl isocyanurate, or the like.

As a further example, when both B and C are carboxylic acid or carboxylic acid chlorides, the substituted pyrene moiety can form a polyester by reacting with a dialcohot or can form a polyamide by reacting with a diamine, wherein the individual amine groups in the diamine are either primary or secondary amines. As a further example, when B is a carboxylic acid and C is a hydroxy, a polyester can be formed by using the disubstituted pyrene monomer.

Other substituted or functionalized fused-ring aromatic and heteroaromatic moieties such as naphthalene (A), anthracene (D/A), phenanthrene (A), tetracene (D/A), pentacene (D/A), triphenylene (A), triptycene, fluorenone (A), phthalocyanine (D/A), tetrabenzoporphine (D/A), or the like may be covalently bonded to the polymer in a manner similar to the pyrene as outlined above.

The substituted 2-amino-1 H-imidazole-4,5-dicarbonitrile (AIDCN) moiety as shown in structure (III) can be covalently bonded to a polymer in several ways as will be described below:

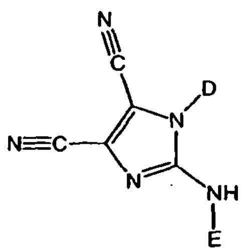

III

where, in structure (III), D and E can be a hydrogen, a direct amide bond to a carboxylic acid group such as, for example, a (meth)acrylic acid monomer, a methylol, or a vinyl group. D or E may be an aryl group or a linear, branched or cyclic alkyl group having 1 to 26 carbon atoms. As detailed above, hydroxy groups can form esters with a carboxylic acid group, such as, for example in a (meth)acrylate monomer to create a pendant group and the vinyl group can couple

directly into the backbone of the polymer. In addition, it is also possible to form amide-ester type polymers.

Substituted carbazole moieties such as those shown in structure (IV) are electron donors and can be covalently bonded to a polymer:

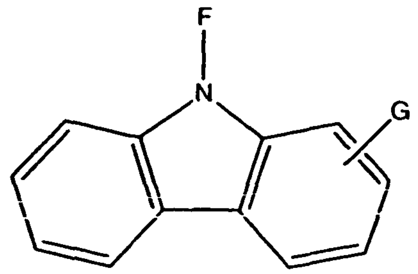

IV

wherein F can be a hydrogen, a direct amide bond to a carboxylic acid group such as, for example, in a (meth)acrylic acid monomer, a methylol, or a vinyl group and G can be a hydrogen, vinyl, methylol, hydroxy, primary amine, secondary amine, carboxylic acid, carboxylic acid chloride, or sulfonic acid. The vinyl group can bond the carbazole moiety covalently to the polymer by incorporating the vinyl group into the backbone of the polymer while the methylol, hydroxy, primary amine and secondary amine groups can bond the carbazole moiety covalently to the polymer as a pendant group. The carboxylic acid, carboxylic acid chloride and sulfonic acid groups bond the carbazole moiety covalently to the polymer as a pendant group as may be demonstrated in a vinyl alcohol carboxylic acid ester or a vinyl alcohol sulfonic acid ester.

Substituted ferrocenes as shown in the structures (V), (VI) and (VII) behave as electron donors and can be covalently bonded to a polymer,

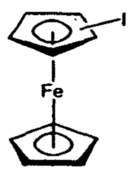

V

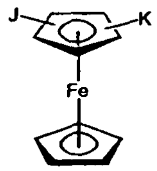

VI

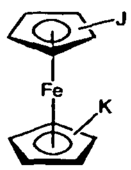

VII

wherein I in structure (V) can be vinyl, methylol, hydroxy, primary amine, secondary amine, carboxylic acid, carboxylic acid chloride, or sulfonic acid. The vinyl group bonds the ferrocene moiety covalently to the polymer by incorporating the vinyl group into the backbone of the polymer while the methylol, hydroxy, primary amine and secondary amine groups bond the ferrocene moiety covalently to the polymer as a pendant group such as might be the case in a (meth)acrylate monomer group. The carboxylic acid, carboxylic acid chloride, and sulfonic acid groups bond the ferrocene moiety covalently to the polymer in pendent fashion such as might be the case in a vinyl alcohol carboxylic acid ester or a vinyl alcohol sulfonic acid ester.

J and K, in structures (VI) and (VII) can be the same or different and can be a hydrogen, vinyl, methylol, hydroxy, primary amine, secondary amine, carboxylic acid, carboxylic acid chloride, or sulfonic acid. It is understood that the chemistry outlined here also permits the formation of polyesters and polyamides, vinyl substituted polymers and crosslinked polymers analogous to those outlined above.

Substituted dibenzochalcophene moieties as may be seen in structures (VIII) and (IX) can also be covalently bonded to a polymer.

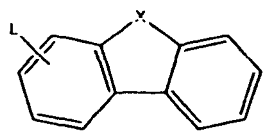

VIII

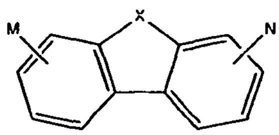

IX

In the structures (VIII) and (IX), X can be chalcogen, L can be vinyl, methylol, hydroxy, primary amine, secondary amine, carboxylic acid, carboxylic acid chloride, or sulfonic acid. The vinyl group bonds the dibenzochalcophene moiety covalently to the polymer by incorporating the vinyl group into the backbone of the polymer while the methylol, hydroxy, primary amine and secondary amine groups bond the dibenzocbalcophene moiety covalently to the polymer as a pendant group such as might be demonstrated in a (meth)acrylate monomer group. The carboxylic acid, carboxylic acid chloride, and sulfonic acid groups bond the dibenzochalcophene moiety covalently to the polymer in pendent fashion such as may be seen in a vinyl alcohol carboxylic acid ester or in a vinyl alcohol sulfonic acid ester. In the structures (VIII) and (IX) shown above, when X is sulfur, the moiety behaves as a donor, while when X is selenium, the structure behaves as an acceptor.

M and N can be the same or different and can be a hydrogen, vinyl, methylol, hydroxy, primary amine, secondary amine, carboxylic acid, carboxylic acid chloride, or sulfonic acid. It is understood that the chemistry outlined here also permits the formation of polyesters and polyamides, vinyl substituted polymers and crosslinked polymers analogous to those outlined above. In order that M and/or N bond the dibenzochalcophene moiety covalently to the polymer, if M is hydrogen then N can not be hydrogen and vice versa.

Substituted phenothiazine (D/A) moieties as shown in structure (X) can also be covalently bonded to a polymer,

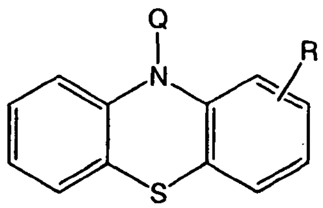

X

wherein Q can be a hydrogen, a methylol, or a vinyl group and R can be a hydrogen, vinyl, methylol, hydroxy, primary amine, secondary amine, carboxylic acid, carboxylic acid chloride, or sulfonic acid. The vinyl group bonds the phenothiazine moiety covalently to the polymer by incorporating the vinyl group into the backbone of the polymer while the methylol, hydroxy, primary amine and secondary amine groups bond the phenothiazine moiety covalently to the polymer as a pendant group such as might be seen when covalently bonding an amide or ester to a (meth)acrylate monomer group. The carboxylic acid, carboxylic acid chloride, and sulfonic acid groups bond the phenothiazine moiety convalently to the polymer as a pendant group such as may be seen in a vinyl alcohol carboxylic acid ester or a vinyl alcohol sulfonic acid ester.

It is understood that the chemistry outlined here also permits the formation of polyesters, polyamides, vinyl polymers and crosslinked polymers analogous to those outlined above. In order that Q and/or R bond the phenothiazine moiety covalently to the polymer, if Q is hydrogen then R can not be hydrogen and vice versa. Other molecules that can be used in a manner similar with phenothiazine are 1,4-dihydro-quinoxaline which behaves as a donor acceptor complex, 5,10-dihydro-phenazine which behaves as a donor and 5,7,12,14-tetrahydroquinoxalino[2,3-b]phenazine which behaves as a donor.

Substituted tetrathiafulvalene (TTF) as shown in structure (XI) can be covalently bonded to the polymer,

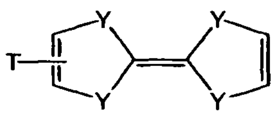

XI

wherein Y is sulfur or selenium and T can be vinyl, methylol, hydroxy, primary amine, secondary amine, carboxylic acid, carboxylic acid chloride, or sulfonic acid. The vinyl group bonds the tetrathiafulvalene or tetraselenafulvalene moiety covalently to the polymer by incorporating the vinyl group into the backbone of the polymer while the methylol, hydroxy, primary amine and secondary amine groups bond the tetrathiafulvalene or tetraselenafulvalene moiety covalently to the polymer as a pendant group such as may be seen in a (meth)acrylate monomer group. The carboxylic acid, carboxylic acid chloride and sulfonic acid groups bond the tetrathiafulvalene or tetraselenafulvalene moiety covalently to the polymer in pendent fashion such as may be seen in a vinyl alcohol carboxylic acid ester or a vinyl alcohol sulfonic acid ester.

Substituted bisaryl azo moieties as may be seen in structures (XII), (XIII) or (XVI) generally behave as donor-acceptor complexes and can also be covalently bonded to the polymer.

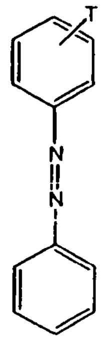
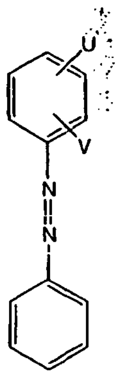
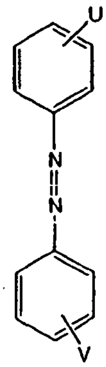

XII XIII XIV

The structures (XII), (XM) or (XVI) may be either in the syn or anti isomeric forms. In the structures (XII), (XIII) or (XVI), T can be vinyl, methylol, hydroxy, primary amine, secondary amine, carboxylic acid, carboxylic acid chloride, or sulfonic acid, wherein the vinyl group bonds the bisaryl azo moiety covalently to the polymer by incorporating the vinyl group into the backbone of the polymer while the methylol, hydroxy, primary amine and secondary amine groups bond the bisaryl azo moiety covalently to the polymer as a pendant group such as may be seen in a (meth)acrylate monomer group. The carboxylic acid, carboxylic acid chloride, and sulfonic acid groups bond the bisaryl azo moiety covalently to the polymer as a pendant group as may be seen in a vinyl alcohol carboxylic acid ester or a vinyl alcohol sulfonic acid ester. In the structures (XIII) and (XVI), U and V can be the same or different and can be hydrogen, vinyl, methylol, hydroxy, primary amine, secondary amine, carboxylic acid, carboxylic acid chloride, or sulfonic acid. It is understood that the chemistry outlined here also permits the formation of polyesters and polyamides, vinyl substituted polymers and crosslinked polymers analogous to those outlined above. In order that U and/or V bond the bisaryl azo moiety covalently to the polymer, if U is hydrogen then V cannot be hydrogen and vice versa.

Substituted coumarin moieties as shown in structures (XV) behave as electron acceptors and also can be covalently bonded to the polymer,

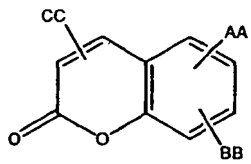

XV

wherein AA, BB and CC can be the same or different and can be a hydrogen, vinyl, methylol, hydroxy, primary amine, secondary amine, carboxylic acid, carboxylic acid chloride, or sulfonic acid. It is understood that the chemistry outlined here also permits the formation of polyesters and polyamides, vinyl substituted polymers and crosslinked polymers analogous to those outlined above. In order that AA and/or BB and/or CC covalently bond the coumarin moiety to the polymer, at least one of AA, BB or CC cannot be hydrogen.

Substituted phenazine and acridine moieties as shown in structures (XVI) and (XVII) can also be covalently bonded to the polymer.

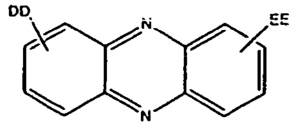

Phenazine

XVI

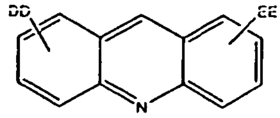

acridine

XVII

In the structures (XVI) and (XVII), DD and EE can be the same or different and can be a hydrogen, vinyl, methylol,

hydroxy, primary amine, secondary amine, carboxylic acid, carboxylic acid chloride, or sulfonic acid. It is understood that the chemistry outlined here also permits the formation of polyesters and polyamides, vinyl substituted polymers and crosslinked polymers analogous to those outlined above. In order that DD and/or EE bond the phenazine or acridine moiety covalently to the polymer, if DD is hydrogen then EE can not be hydrogen and vice versa.

Substituted quinoline or isoquinoline moieties as shown in the structures (XVIII) or (XIX), both of which behave as electron acceptors can also be covalently bonded to the polymer.

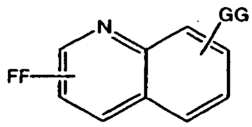

Quinoline

XVIII

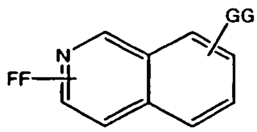

Isoquinoline

XIX

In the structures (XVIII) and (XIX), FF and GG can be the same or different and can be a hydrogen, vinyl, methylol, hydroxy, primary amine, secondary amine, carboxylic acid, carboxylic acid chloride, or sulfonic acid. It is understood that the chemistry outlined here also permits the formation of polyesters and polyamides, vinyl substituted polymers and crosslinked polymers analogous to those outlined above. In order that FF and/or GG bond the quinoline or isoquinoline moiety covalently to the polymer, if FF is hydrogen then GG can not be hydrogen and vice versa.

Substituted pentafluoroaniline moieties as shown in structure (XX) behave as electron acceptors and can also be covalently bonded to the polymer.

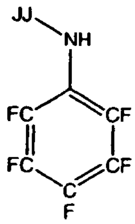

XX

In the structure (XX), JJ can be a vinyl or methylol.

Substituted anthraquinone moieties as shown in structure (XXI) also behave as electron acceptors and can also be covalently bonded to the polymer.

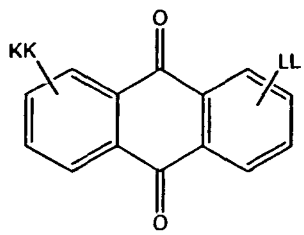

XXI

In the structure (XXI), KK and LL can be the same or different and can be a hydrogen, vinyl, methylol, hydroxy, primary amine, secondary amine, carboxylic acid, carboxylic acid chloride, or sulfonic acid. It is understood that the chemistry outlined here also permits the formation of polyesters and polyamides, vinyl substituted polymers and crosslinked polymers analogous to those outlined above. In order that KK and/or LL bond the anthraquinone moiety covalently to the polymer, if FF is hydrogen then KK can not be hydrogen and vice versa. Compounds having a dicyanomethylene group substituted for one or both oxygen atoms such as tetracyanoanthraquinodimethane (TCNA) (generally an electron acceptor) can also be covalently bonded to a polymer in a manner analogous to those described above.

Substituted tetracyanoquinodimethane (TCNQ) moieties shown in structure (XXII) generally behaves as an

electron acceptor and can be covalently bonded to the polymer.

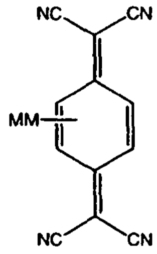

XXII

In the structure (XXII), MM can be vinyl, methylol, hydroxy, primary amine, secondary amine, carboxylic acid, carboxylic acid chloride, or sulfonic acid. These functional groups serve to bond the TCNQ moiety covalently to the polymer either by incorporating it into the polymer backbone, as with vinyl substitution or by incorporating it as a pendant group as described above.

Also useful as electroactive moieties are inherently conducting or semiconducting polymers. Examples of such conducting or semiconducting polymers that are inherent electroactive moieties include polyanilines, polypyrroles, polythiophenes, pulyselenophenes, polybenzothiophenes, polybenzoselenophenes, poly(2,3-dihydro-thieno[3,4-b][1,4]dioxine) (PEDOT), polyphenylene-vinylenes, poly(p-phenylene), poly(p-pyridyl phenylene), polyacetylenes, pyrolyzed polyacrylonitrile, or the like, or a combination comprising at least one of the foregoing conducting or semiconducting polymers. These inherently conducting or semiconducting polymers generally act as electron donors and can be formulated with one or more electron acceptors whether or not the electron acceptors are covalently bonded to another polymer. A polymer that is suitable for use as an electron acceptor is poly[(7-oxo-7H,12H-benz[de]-imidazo[4',5':5,6] benzimidazo [2,1-a] isoquinoline-3,4:11,12-tetra-yl)-12-carbonyl] (BBL).

In the forgoing as well as in the following, primary and secondary amine groups are represented as -NHR, wherein R can be hydrogen, an alkyl having 1 to 20 carbon atoms, an aryl having 6 to 26 carbon atoms, a dialkyl ether group having 1 to 12 carbon atoms in the first segment and 1 to 12 carbon atoms in the second segment, an alkylaryl group having 7 to 24 carbon atoms, an arylalkyl group having 7 to 24 carbon atoms, a hydroxy-terminated alkyl group having 1 to 20 carbon atoms, a keto-substituted alkyl group having 3 to 20 carbon atoms, an alkyl or aryl carboxylic acid ester having 1 to 12 carbon atoms in the carboxylic acid segment and 1 to 12 carbon atoms on the alcoholic or phenolic segment, a carbonate ester having 1 to 12 carbon atoms in the first alcohol segment and 1 to 12 carbon atoms in the second alcohol segment, or the like. Further, it is contemplated that other substitutions which may or may not participate in the covalent bonding to a polymer such as alkyl groups having 1 to 20 carbon atoms, aldehydes, ketones, carboxylic acids, esters, ethers and the like having 1 to 20 carbon atoms alkylaryl compounds having 7 to 20 carbon atoms, arylalkyl compounds having 7 to 20 carbon atoms or other substitution can be made to improve solubility, polymer compatibility, film forming characteristics, thermal properties and the like. For example, 6-hydroxy-4-methyl chromen-2-one can be used as a substituted coumarin.

The polymers have number average molecular weights of 500 to 1,000,000 grams/mole. In one embodiment, the polymers have number average molecular weights of 3,000 to 500,000 grams/mole. In another embodiment, the polymers have number average molecular weights of 5,000 to 100,000 grams/mole. In yet another embodiment, the polymers have number average molecular weights of 10,000 to 30,000 grams/mole. The molecular weight of the polymer may be determined by gel permeation chromatography.

The crosslinking is generally brought about by the functional groups that are covalently bonded to the backbone of polymer. However, other crosslinking agents that are not covalently bonded to the polymers may also enhance crosslinking. It is generally desirable for the crosslinking agents to have a functionality of greater than or equal to about 2. Suitable examples of such crosslinking agents are silanes, ethylenically unsaturated resins, aminoplast resins, phenolics, phenol-formaldehyde resins, epoxies, or the like, or combinations comprising at least one of the foregoing.

Suitable examples of silanes are tetraalkoxysilanes, alkyltrialkoxysilanes, hexamethyldisilazanes, trichloroalkylsilanes, or the like, or combinations comprising at least one of the foregoing. Suitable examples of ethylenically unsaturated resins include olefins (ethylene, propylene), $C_1$-$C_{12}$ alkyl (meth)acrylates, acrylonitrites, alpha-olefins, butadiene, isoprene, ethylenically unsaturated siloxanes, anhydrides, and ethers. In the present specification the term (meth) acrylates encompasses acrylates or methacrylates and the term (meth)acrylonitrile encompasses acrylonitrile or methacrylonitrile.

Suitable examples of other types of crosslinking agents include phenol formaldehyde novolac, phenol formaldehyde resole, furan terpolymer, furan resin, combinations of phenolics and furans, (e.g., resole or novolac), epoxy-modified novolacs, urea-aldehyde resins, melamine-aldehydes, epoxy modified phenolics, glycidyl-substituted isocyanurates such as triglycidyl isocyanurate, other epoxy resins or the like, or combinations comprising at least one of the foregoing crosslinking agents.

The aminoplast resins may be alkylated methylol melamine resins, alkylated methylol urea, or the like, or combinations comprising at least one of the foregoing. Aminoplast resins derived from the reaction of alcohols and/or aldehydes with melamines, glycolurils, urea and/or benzoguanamines are generally preferred.

Suitable examples of alcohols that may be used in the production of aminoplast resins are monohydric alcohols such as methanol, ethanol, propanol, butanol, pentanol, hexanol, heptanol, or the like, aromatic alcohols such as benzyl alcohol, resorcinol, pyrogallol, pyrocatechol, hydroquinone, or the like, cyclic alcohol such as cyclohexanol, monoethers of glycols such as cellosolve, carbitol, or the like, halogen-substituted or other substituted alcohols such as 3-chloropropanol, butoxyethanol, or the like, or combinations comprising at least one of the foregoing alcohols. Suitable examples of aldehydes that may be used in the production of aminoplast resins are formaldehyde, acetaldehyde, crotonaldehyde, acrolein, benzaldehyde, furfural, glycols or the like, or combinations comprising at least one of the foregoing aldehydes.

Condensation products of other amines and amides can also be employed as crosslinking agents. Aldehyde condensates of triazines, diazines, triazoles, guanadines, guanamines and alkyl- and aryl-substituted derivatives of such compounds, including alkyl- and aryl-substituted ureas and alkyl- and aryl-substituted melamines may also be employed as crosslinking agents. Suitable example of such compounds are N,N'-dimethyl urea, benzourea, dicyandiamide, formaguanamine, acetoguanamine, ammeline, 2-chloro-4,6-diamino-1,3,5-triazine, 6-methyl-2,4-diamino-1,3,5-triazine. 3,5-diaminotriazole, triaminopyrimidine, 2-mercapto-4,6-diaminopyrimidine, 3,4,6-tris(ethylamino)-1,3,5-triazine, 1,3,4,6-tetrakis(methoxymethyl) letrahydro-imidazo[4,5-d]imidazole-2,5-dione (sold under the name of Powderlink 1174, Cytec Industries, Inc.), 1,3,4,6-tetrakis(butoxymethyl) tetrahydro-imidazo[4,5-d]imidazole-2,5-dione, N,N,N',N',N",N"-hexakis(methoxymethyl)-1,3,5-triazine-2,4,6-triamine, N,N,N',N',N",N"-hexakis(butoxymethyl)-1,3,5-triazine-2,4,6-triamine, 3a-butyl-1,3,4,6-glycoluril, 1,3,4,6-tetrakis(methoxymethyl), 3a-butyl-1,3,4,6-tetrakis(butoxymethyl) 6a-methyltetrahydro-imidazo[4,5]-dlimidazole-2,5-dione, or the like.

In one embodiment, it is desirable to use aminoplast resins that contain alkylol groups. It is generally desirable to etherify a portion of these alkylol groups to provide solvent-soluble resins. More preferred aminoplast resins are those that are etherified with methanol or butanol.

It is generally desirable to use the crosslinking agent in an amount of 0.01 to 20 wt% based on the total weight of the electric field programmable film. In one embodiment, it is desirable to use the crosslinking agent in an amount of 0.1 to 15 wt%, based on the total weight of the film. In another embodiment, it is desirable to use the crosslinking agent in an amount of 0.5 to 10 wt%, based on the total weight of the film. In yet another embodiment, it is desirable to use the crosslinking agent in an amount of 1 to 7 wt%. based on the total weight of the film. An exemplary amount of acid and/or acid generator is 6 wt%, based on the total weight of the electric field programmable film.

The electric field programmable film composition may further comprise an acid and/or acid generator for catalyzing or promoting crosslinking during curing of the film composition. Suitable acids include aromatic sulfonic acids such as toluene sulfonic acid, benzene sulfonic acid, p-dodecylbenzene sulfonic acid; fluorinated alkyl or aromatic sulfonic acids such as o-trifluoromethylbenzene sulfonic acid, triflic acid, perfluoro butane sulfonic acid, perfluoro octane sulfonic acid or the like, or combinations comprising at least one of the foregoing acids. In one embodiment, the acid generators are thermal acid generators. In another embodiment, the thermal acid generators generate a sulfonic acid upon activation. Suitable thermal acid generators are alkyl esters of organic sulfonic acids such as 2,4,4,6-tetrabromocyclohexadienone, benzoin tosylate, 2-nitrobenzyl tosylate, 4-nitrobenzyl tosylate, or the like, or a combination comprising at least one of the foregoing.

It is generally desirable to use the acid and/or acid generator in the electric field programmable film in an amount of 0.01 to 10 wt% based on the total weight of the film. In one embodiment, it is desirable to use the acid and/or acid generator in the electric field programmable film in an amount of 0.1 to 8 wt% based on the total weight of the film. In another embodiment, it is desirable to use the acid and/or acid generator in the electric field programmable film in an amount of 0.5 to 5 wt% based on the total weight of the film. In yet another embodiment, it is desirable to use the acid and/or acid generator in the electric field programmable film in an amount of 1 to 3 wt% based on the total weight of the film. An exemplary amount of acid and/or acid generator is 2 wt% based on the total weight of the electric field programmable film.

As stated above, the polymers are bonded to an electroactive moiety which may be an electron donor and/or and electron acceptor and/or a donor-acceptor complex via a functional group. The electroactive moiety may have a protective shell if desired. The electroactive moiety can be, for example, functional groups, molecules, nanoparticles or particles.

Electron donors may be organic or inorganic electron donors. The electron donors can for example have an average size of up to 100 nanometers (nm) and may optionally contain protective organic and/or inorganic shells. The electron donors may comprise metals, metal oxides, metalloid atoms, semiconductor atoms, or a combination comprising at least one of the foregoing. The protective organic and/or inorganic shells prevent aggregation of the electron donors.

The electron donors used are preferably less than or equal to 10 nm in diameter. The size of the nanoparticle may be engineered to meet the needs of the particular device and the temperature of operation. The band gap, δ, of a nanoparticle comprising metal atoms and having a given size may be estimated by the Kubo formula (I)

$$\delta \approx \frac{4 \cdot E_F}{3 \cdot N} \qquad \text{(I)}$$

where $E_F$ is the Fermi energy of the bulk metal (usually about 5 eV) and N is the number of atoms in the particles formed from the atoms of the electron donor. The particles formed from the atoms of the electron donor may display metallic behavior, semiconducting behavior or insulating behavior depending upon the temperature. The size of the particles is generally temperature dependent and is inversely proportional to temperature. At lower temperatures, in order to display metallic behavior, the particle sizes are generally larger, while at higher temperatures, the particles can display metallic behavior at lower particle sizes.

The particles of the electron donor may exhibit a coulomb blockade effect that is characteristic of semiconductor particles. This is desirable in situations where only a small number of charge carriers is required for the operation of the device. In such situations, nanoparticles of the order of 1 nm are desirable for room temperature operation.

As noted above, it is desirable for the electron donors to have an average particle size of up to about 100 nm. Within this range, it is generally desirable to have organic electron donors greater than or equal to 2, greater than or equal to 3, and greater than or equal to 5 nm. Also desirable, within this range, it is generally desirable to have organic electron donors less than or equal to 90, less than or equal to 75, and less than or equal to 60 nm. The size of the electron donors and the electron acceptors may be measured by techniques such as low angle xray scattering, scanning or transmission electron microscopy or atomic force microscopy.

The optional protective shells usually render the electron donor particles soluble in a suitable solvent. The thickness of the protective shell may also vary the amount of electron tunneling that can take place. Thus the thickness of the protective layer may be varied depending upon the electron tunneling and dissolution characteristics desired of the system. For example, in a memory device where it is desirable for a stored charge to have a long life, a thicker protective shell around a charge donor will prevent electron recombination thereby preserving the stored charge. The thickness of the protective shell depends on the particular moiety as well as on the solvents and solutes in the solution. The average protective shells for organic electron donors are up to about 10 nm in thickness. Within this range, it is generally desirable to have a protective shell of greater than or equal to 1.5, and greater than or equal to 2 nm. Also desirable, within this range, it is generally desirable to a protective shell of less than or equal to 9, less than or equal to 8, and less than or equal to 6 nm.

Suitable examples of organic electron donor moieties include, but are not limited to tetrathiafulvalene, 4,4',5-trimethyltetrathiafulvalene, bis(ethylenedithio)tetrathiafulvalene, p-phenylenediamine, N-ethylcarbazole, tetrathiotetracene, hexamethylbenzene, tetramethyltetraselenofulvalene, hexamethylenetetraselenofulvalene, or the like, or combinations comprising at least one of the foregoing.

Inorganic electron donors are formed generally by reducing metal-halide salts or metal-halide complexes of transition metals such as iron (Fe), manganese (Mn), cobalt (Co), nickel (Ni), copper (Cu), ruthenium (Ru), rhodium (Rh), palladium (Pd), silver (Ag), rhenium (Re), osmium (Os), iridium (Ir), platinum (Pt) or gold (Au). The halide complexes and salts are generally reduced with $NaBEt_3H$ or $NR4^+$ $BEt_3H$, $NaBH_4$, ascorbic acid, citric acid or other suitable reducing agent in the presence of RSH, RR'R"N, RR'R"R"'N+, RR'R"P or the like, wherein R, R', R" and R"' each can be the same or different and represent hydrogen, an alkyl having 4 to 20 carbon atoms, an aryl or a fused ring aryl having 6 to 26 carbon atoms, a dialkyl ether group having 1 to 12 carbon atoms in the first segment and 1 to 12 carbon atoms in the second segment, an alkylaryl group having 7 to 24 carbon atoms, an arylalkyl group having 7 to 24 carbon atoms, a hydroxy-terminated alkyl group having 1 to 20 carbon atoms, a keto-substituted alkyl group having 4 to 20 carbon atoms, an alkyl or aryl carboxylic acid ester having 1 to 12 carbon atoms in the carboxylic acid segment and 1 to 12 carbon atoms on the alcoholic or phenolic segment, a carbonate ester having 1 to 12 carbon atoms in the first alcohol segment and 1 to 12 carbon atoms in the second alcohol segment or the like. In the forgoing, alkyl groups may be linear, cyclic or branched. The reduction is generally carried out in the presence of tetrahydrofuran, 2,2'bipyridine, 8-hydroxyquinoline, or other suitable ligands which facilitate the formation of a protective shell on the electron donor.

In one embodiment, the protective shell comprises a silicon oxide; an RS- group wherein R is an alkyl having 1 to 24 carbon atoms, a cycloalkyl having 1 to 24 carbon atoms, an arylalkyl having 7 to 24 carbon atoms, an alkylaryl having 7 to 24 carbon atoms, an ether having 1 to 24 carbon atoms, a ketone having I to 24 carbon atoms, an ester having 1 to 24 carbon atoms, a thioether having 1 to 24 carbon atoms, or an alcohol having 1 to 24 carbon atoms; an RR'N- group wherein R and R' can be the same or different and can be hydrogen, an alkyl having 1 to 24 carbon atoms, a cycloalkyl having 1 to 24 carbon atoms, an arylalkyl having 7 to 24 carbon atoms, an alkylaryl having 7 to 24 carbon

atoms, an ether having 1 to 24 carbon atoms, a ketone having I to 24 carbon atoms, an ester having 1 to 24 carbon atoms, a thioether having 1 to 24 carbon atoms, or an alcohol having 1 to 24 carbon atoms; tetrahydrofuran, tetrahydrothiophene or a combination comprising at least one of the foregoing.

Tetrahydrothiophene may be used to stabilize manganese (Mn), palladium (Pd) and platinum (Pt) containing electron donors. These inorganic electron donors are made by reducing the metal salts such as manganese bromide ($MnBr_2$), platinum chloride ($PtCl_2$) and palladium chloride ($PdCl_2$) with potassium triethylborohydride ($K^+$ $BEt_3H^-$) or letraalkylammoniurn borohydride ($NR4^+$ $BEt_3H^-$) (wherein R is an alkyl having 6 to 20 carbon atoms) in the presence of tetrahydrothiophene. Betaine surfactants may also be used as stabilizers to form the protective shells on the electron donor particles.

In another embodiment, inorganic and/or organometallic nanoparticle electron donors are derived from transition metals such as Fe, Co, Ni, Cu, Ru, Rh, Pd, Ag, Re, Os, Ir, Pt and Au by reducing their halide salts, halide complexes or their acetylacetonate (ACAC) complexes with reducing agents such as $NaBEt_3H$, $NR4^+$ $BEt_3H^-$, $NaBH_4$, ascorbic acid, citric acid, or the like. In yet another embodiment, mixed metal inorganic electron donors may be obtained by reducing mixtures of transition metal halide salts, their halide complexes and their ACAC complexes. In yet another embodiment, electrochemical reduction of the halide salts, halide complexes or the ACAC complexes of Fe, Co, Ni, Cu, Ru, Rh, Pd, Ag, Re, Os, Ir, Pt and Au are also used to prepare inorganic electron donors using a variety of stabilizers such as THF, tetrahydrothiophene, alkane thiols having 1 to 20 carbon atoms, alkylamines having 1 to 20 carbon atoms, or betaine surfactants.

The electron donors are generally present in the electric field programmable film in an amount of 1 to 30 weight percent (wt%); where the weight percent is based on the total weight of the electric field programmable film. In one embodiment, the electron donors may be present in the electric field programmable film in an amount of 5 to 28 wt%. In another embodiment, the electron donors may be present in the electric field programmable film in an amount of 10 to 26 wt%. In yet another embodiment, the electron donors may be present in the electric field programmable film in an amount of 15 to 25 wt%.

The selection of the optimum electron acceptor is influenced by its electron affinity. It is possible to use one or more electron acceptors to minimize threshold voltages while offering improved environmental stability. It is also possible to use a plurality of different electron donors, acceptors, and/or donor/acceptor complexes to provide multiple switching characteristics, thereby implementing the storage of multiple bits in a single element of the film. Suitable examples of electron acceptors include 8-hydroxyquinoline, phenothiazine, 9,10-dimethylanthracene, pentafluoroaniline, phthalocyanine, perfluorophthalicyanine, tetraphenylporphine, copper phthalocyanine, copper perfluorophthalocyanine, copper tetraphenylporphine, 2-(9-dicyanomethylene-spiro[5.5]undec-3-ylidene)-malononitrile, 4-phenylazo-benzene-1,3-diol, 4-(pyridin-2-ylazo)-benzene-1,3-diol, benzo[1,2,5]thiadiazole-4,7-dicarbonitrile, tetracyanoquinodimethane, quinoline, chlorpromazine, or the like, or combinations comprising at least one of the foregoing electron acceptors.

The electron acceptors are preferably nanoparticles and generally have particle sizes of 1 to 100 nm. Within this range, it is generally desirable to have electron acceptors greater than or equal to 1.5, greater than or equal to 2 nm. Also desirable, within this range, it is generally desirable to have electron acceptors less than or equal to 50, less than or equal to 25, and less than or equal to 15 nm. Suitable acceptor nanoparticles include but are not limited to antimony tin oxide, copper oxide and goethite (FeOOH).

The electron acceptors are generally present in the electric field programmable film in an amount of 1 to 30 wt%, based on the total weight of the film. In one embodiment, the electron acceptors may be present in the electric field programmable film in an amount of 5 to 28 wt%. In another embodiment, the electron acceptors may be present in the electric field programmable film in an amount of 10 to 26 wt%. In yet another embodiment, the electron acceptors may be present in the electric field programmable film in an amount of 15 to 25 wt%.

When electron donors and electron acceptors, whether or not they are bound to the polymer, are to be combined in the same formulation, it is believed that some donors and acceptors will react to form donor-acceptor complexes or, alternatively, charge-transfer salts. The extent of reaction depends on the electron affinity of the electron donor, the ionization potential of the electron acceptor, kinetic factors such as activation energies, activation entropies and activation volumes, and energies attributable to matrix effects. In addition to forming spontaneously as a result of a reaction between electron donors and electron acceptors, donor-acceptor complexes can be optionally added to the formulation to adjust "on" and "off" threshold voltages, "on" state currents, "off" state currents and the like. It is also contemplated that donor acceptor complexes, whether or not they are bound to the polymer, can be added separately to the film in order to adjust threshold on and off voltages. It is further contemplated that both the donor and acceptor portions of the donor-acceptor complex may be bound to the polymer.

A wide array of donor-acceptor complexes may be used. Such complexes include, but are not limited to, tetrathiafulvalene - tetracyanoquinodimethane; hexamethylenetetrathiafulvalene - tetracyanoquinodimethane; tetraselenafulvalene - tetracyanoquinodimethane; hexamethylenetetraselenafulvalene - tetracyanoquinodimethane; methylcarbazole - tetracyanoquinodimethane; tetramethyltetraselenofulvalene - tetracyanoquinodimethane; metal nanoparticle- tetracyanoquinodimethane complexes comprising gold, copper, silver or iron, ferrocene - tetracyanoquinodimethane

complexes; tetrathiotetracene, tetramethyl-p-phenylenediamine, or hexamethylbenzene - tetracyanoquinodimethane complexes; tetrathiafulvalene, hexamethylenetetrathiafulvalene, tetraselenafulvalene, hexamethylenetetraselenafulvalene, or tetramethyltetraselenofulvalene-N-alkylcarbazole($C_1$- $C_{10}$, linear or branched) complexes; tetrathiotetracene, tetramethyl-p-phenylenediamine, or hexamethylbenzene-Buckminsterfullerene $C_{60}$ complexes; tetrathiafulvalene, hexamethylenetetrathiafulvalene, tetraselenafulvalene, hexamethylenetetraseienafulvalene, or tetramethyltetraselenofulvalene-N-alkylcarbazole($C_1$ - $C_{10}$, linear or branched) complexes; tetrathiotetracene, tetramethyl-p-phenylenediamine, or hexamethylbenzene-tetracyanobenzene complexes, tetrathiafulvalene, hexamethylenetetrathiafulvalene, tetraselenafulvalene, hexamethylenetetraselenafulvalene, or tettamethyltetraselenofulvalene-N-alkylcarbazole($C_1$- $C_{10}$, linear or branched) complexes, tetrathiotetracene, tetramethyl-p-phenylenediamine, or hexamethylbenzene-tetracyanoethytene complexes; tetrathiafulvalene, hexamethylenetetrathiafulvalene, tetraselenafulvalene, hexamethylenetetraselenafulvalene, or tetramethyltetraselenofulvalene-N-alkylcarbazole($C_1$ - $C_{10}$, linear or branched) complexes, tetrathiotetracene, tetramethyl-p-phenylenediamine, or hexamethylbenzene-p-chioranil complexes, or combinations comprising at least one of the foregoing donor-acceptor complexes.

When donor-acceptor complexes are used, they are generally present in the electric field programmable film in an amount of 0.05 to 5 wt%, based on the total weight of the film. In one embodiment, the donor-acceptor complexes are present in the electric field programmable film in an amount of 0.5 to 4 wt%, based on the total weight of the film. In another embodiment, the donor-acceptor complexes are present in the electric field programmable film in an amount of 1 to 3.5 wt%, based on the total weight of the film. In yet another embodiment, the donor-acceptor complexes are present in the electric field programmable film in an amount of 1.5 to 3 wt%, based on the total weight of the film.

The electric field programmable film may be manufactured by several different methods. In one method of manufacturing the film, a composition comprising a polymer covalently bonded to the electron acceptors and/or electron donors and/or donor-acceptor complexes is deposited on a substrate. The composition is then either dried or cured to form the electric field programmable film. In another method of manufacturing the film, the polymer may be reacted with the desired electron acceptors and/or electron donors and/or donor-acceptor complexes in the presence of an optional solvent. The film is then cast from solution and the solvent is evaporated at a suitable temperature. The film may be cast by a number of different methods. Suitable examples are spin coating, spray coating, electrostatic coating, dip coating, blade coating, slot coating, or the like. The electric field programmable film may also be manufactured by processes such as injection molding, vacuum forming, blow molding, compression molding, patch die coating, extrusion coating, slide or cascade coating, curtain coating, roll coating such as forward and reverse roll coating, gravure coating, meniscus coating, brush coating, air knife coating, silk screen printing processes, thermal printing processes, ink jet printing processes, direct transfer such as laser assisted ablation from a carrier, self-assembly or direct growth, electrodeposition, electroless deposition, electropolymerization or the like.

In another method of manufacturing, a reactive precursor to the polymer may be first reacted with the desired electron acceptors and/or electron donors and/or donor-acceptor complexes. The reactive precursors are then reacted to form the polymer. The polymer may additionally be crosslinked if desired.

It is generally desirable for solvents used during the manufacturing process, to be capable of solubilizing the polymer and/or the electron donors and/or the electron acceptors and/or the optional donor-acceptor complexes. Suitable solvents include 1,2-dichlaro-benzene, anisole, mixed xylene isomers, o-xylene, p-xylene, m-xylene, diethyl carbonate, propylene carbonate, $R^1$-CO-$R^2$, $R^1$-COO-$R^2$ and $R^1$-COO-$R^3$-COO-$R^2$ wherein $R^1$ and $R^2$ can be the same or different and represent linear, cyclic or branched alkyl alkylene, alkyne, benzyl or aryl moieties having 1 to 10 carbon atoms, and $R^3$ is a linear or branched divalent alkylene having 1 to 6 carbon atoms. Further, other suitable solvent systems may comprise blends of any of the forgoing.

The electric field programmable film may also optionally contain processing agents such as surfactants, mold release agents, accelerators, anti-oxidants, thermal stabilizers, anti-ozonants, fillers, fibers, and the like.

It is desirable for the electric field programmable film to have a thickness of 5 to 5000 nanometers, depending on the requirements of the device. In general, the switching voltages are linear in the film thickness. For memory devices, requiring switching voltage magnitudes below about 10 V, a film thickness (after optional curing) of about 10 to 100 nm is desirable. For devices requiring switching voltage magnitudes below about 5 V, a film thickness (after optional curing) of 5 to 50 nm is generally desirable.

The electric field programmable film may be used in a cross point array. When the film is used in a cross point array, the electrodes may be electrically coupled to the electric field programmable film. The cross point array may advantageously include an electrical coupling element. An electrical coupling element is a component interposed between the electric field programmable film or electric field programmable film element and the electrode. Examples of electrical coupling elements are metal alloy films, metal composite films, metal chalcogenide films where the chalcogenide is oxide, sulfide, selenide or telluride or combinations thereof, metal pnictide films where the pnictide is nitride, phosphide, arsenide, antimonide or combinations thereof in contact with a bit line or a word line. Exemplary coupling elements may be copper oxides, sulfides and selenides such as iridium oxide or thorium oxide coupled to an iridium or tungsten electrode. An electrical coupling element can provide ohmic contact, contact via a conducting plug, capacitive contact,

contact via an intervening tunnel junction, or contact via an intervening isolation device such as a junction diode, a Schottky diode or a transistor or contact via other electrical devices. A further function of the electrical coupling element may be to provide a chemical or physical barrier between the electrode and the field programmable film thereby mitigating electromigration or other physical contamination of the field programmable film.

Other embodiments include devices that respond to optical phenomena. In one embodiment, the electric field programmable film may be programmed and read by applying an electric field and erased by the application of light having a suitable wavelength. For example, electric field programmable films having gold nanoparticles can be erased effectively by the application of light of wavelength less than about 400 nm and more effectively, less than about 365 nm. Electrical programming may be advantageously accomplished by employing an electrode configuration that does not shield the erasing light source, such as a trench configuration with electrodes extending vertically on either side or in a horizontally layered configuration having a transparent electrode electrically coupled to the electric field programmable film and interposed between the electric field programmable film and the light source.

In another embodiment, the electric field programmable film may be programmed and, optionally, erased by the application of light having a suitable wavelength and read electrically. Optical programming and, optionally, erasing may be advantageously accomplished by employing an electrode configuration that does not shield the programming light source, such as a trench configuration with electrodes extending vertically on either side or in a horizontally layered configuration having a transparent electrode electrically coupled to the electric field programmable film and interposed between the electric field programmable film and the light source. For example, electric field programmable films having gold nanoparticles can be programmed effectively by the application of light of wavelength less than about 540 nm and more effectively, less than about 500 nm and, optionally erased by the application of light of wavelength less than about 400 nm and more effectively, less than about 365 nm. Bit-wise optical addressing may be accomplished using near-field optics, in which light from an optionally tapered optical fiber or nanopipette, having a core of higher index of refraction than its cladding, is directed toward the electric field programmable film, or by configured patterned light emitting diodes.

Transparent electrodes may comprise indium tin oxide (ITO), wherein $SnO_2$ is doped into $In_2O_3$ in the range of 1-20% w/w with respect to $In_2O_3$, especially 5-12% w/w, or indium zinc oxide, wherein ZnO is doped into $In_2O_3$ in the range of 1-20% w/w with respect to $In_2O_3$. especially 5-12% w/w. ITO may contain other metal oxides such as $TiO_2$, $PbO_2$, $ZrO_2$, $HfO_2$ ZnO and the like at levels up to about 1% w/w based on oxide. Indium zinc oxide (IZO) may contain other metal oxides such as $TiO_2$, $PbO_2$, $ZrO_2$, $HfO_2$ $SnO_2$ and the like at levels up to about 1% based on oxide. Conductive organic transparent electrodes may also be used. These include poly(3,4-ethylenedioxythiophene)/poly(styrenesulfonate) (PEDOT-PSS), conducting polyesters such as ORGACON™ transparent conductive films, available from Agfa-Gevaert NV, Belgium, and the like. Transparent electrode films should exhibit a transparency greater than about 40%, and more effectively greater than about 50% at or below about 365 nm of wavelength.

The electric field programmable film obtained from the electric field programmable film composition may be used in electronic memory and switching devices or data storage devices. These devices may contain either a single film or multiple films. Devices having multiple films are generally termed stacked devices. The following figures depict a number of exemplary embodiments in which the electric field programmable film may be used. Figure 1 depicts one example of a cross point array that may be used as a memory device. The cross point array comprises a single electric field programmable film, 2, coupled to a first electrode, 3, a second electrode, 4, a variable program/read voltage source connected to the first electrode, 5 and a reference or ground connected to the second electrode, 6. The electrode is disposed upon a surface of the electric field programmable film and in intimate contact with it. In another embodiment, as will be discussed later, the electrodes may move relative to the surface of the electric field programmable film. Figure 2(a) depicts a cutaway view of a cross-point array memory device with a continuous electric field programmable film represented by 7, an array of word lines, an example of which is 8, an array of bit lines, an example of which is 9 and the electric field programmable film element 10 formed by the interposing electric field programmable film 7 at the intersection of word line 8 and bit line 9. Figure 2(b) depicts a cutaway view of a cross-point array data storage device with a plurality of pixelated electric field programmable film elements represented by 11. Each electric field programmable film element is electrically coupled to a word line, exemplified by 12, and a bit line, exemplified by 13. In addition, there are a plurality of electrical coupling elements, exemplified by 14 interposed between the electric field programmable films and the word lines.

Figure 3(a) depicts a schematic diagram of a cross point array memory device comprising electric field programmable film elements, represented by 16, electrically coupled to an exemplary bit line, 17, and an exemplary word line, 18, via exemplary connections, 19 and 20, respectively. Also shown in block diagram form are the sensing electronics, 21 and the polling electronics, 22. Figure 3(b) depicts a schematic diagram of a cross point array device comprising electric field programmable film elements, an example of which is shown by 23, electrically coupled to an exemplary bit line, 24, and an exemplary word line, 25. The electric field programmable film elements are electrically coupled to their respective bit lines, exemplified by the connection at 24, via isolation diodes, an example of which is shown by 27 and further electrically coupled to their respective word lines at 28. Also shown in block diagram form are the polling electronics, 29 and the sensing electronics, 30 used to address the individual bits and amplify the signals obtained from them.

Figure 4 depicts a cutaway partially exploded view of a stacked data storage device on a substrate, 31, comprising a first device layer, having a vertical line array with a plurality of conducting or semiconducting electrodes, exemplified by 32, and an insulating material having a dielectric constant, 33, an electric field programmable film, 34, electrically coupled to the conducting or semiconducting electrodes exemplified by 32 and the conducting or semiconducting electrodes, exemplified by 35, in a horizontal line array with each electrode being isolated from its nearest neighbor by an insulating material having a dielectric constant, exemplified by 36, a second device layer, separated from the first device layer by a dielectric insulating layer, 37, having a vertical line array with a plurality of conducting or semiconducting electrodes, exemplified by 38, and an insulating material having a dielectric constant, 39, an electric field programmable film, 40, electrically coupled to the conducting or semiconducting electrodes exemplified by 38 and the conducting or semiconducting electrodes, exemplified by 41, in a horizontal line array with each electrode being isolated from its nearest neighbor by an insulating material having a dielectric constant, exemplified by 42.

In general, the horizontal lines and the vertical lines intersect each other without direct physical and electrical contact, and wherein at each prescribed intersection of a horizontal line and a vertical line, the horizontal line is electrically coupled to the first surface of the electric field programmable film element and the vertical line is electrically coupled to the second surface of the electric field programmable film element and wherein said stacked data storage device comprises a configuration selected from

$$[H\ P\ V\ D]_{n-1}\ H\ P\ V,$$

$$[V\ P\ H\ D]_{n-1}\ V\ P\ H,$$

$$[H\ P\ V\ P]_{m}\ H,$$

and

$$[V\ P\ H\ P]_{m}\ V,$$

where n-1 and m represent the number of repeating layers, n = 1-32, m = 1- 16, H is a horizontal line array, V is a vertical line array, P is a set of electric field programmable film elements arrayed in essentially coplanar fashion, and D is a dielectric insulating layer.

In addition to single layer memory structures described above, multi-layered structures such as those shown in Figures 4, 5 and 6 may also be constructed. While the figures indicate only a few device layers for simplicity, a larger number is contemplated in accordance with the appended claims.

Figures 4 and 5 show stacked structures separated by a dielectric isolation layer. Such layers form a substantially plane layer-like structure, making it possible to stack such planar layer-like structures, thus forming a volumetric memory device. Isolation layers of this invention are intended to isolate the various layers from one another electrically, capacitively, and, optionally, optically. In addition, the material must be capable of being etched so that via holes can be imparted for the purpose of interconnecting the various layers. Inorganic isolation materials such as silicon oxide, formed by chemical vapor deposition from the decomposition of tetraethylorthosilicate (TEOS) or other orthoester silicates, silicon nitride, silicon oxynitride, titanium dioxide (titania), alumina, zirconia, thoria, iridia, and the like are used for this purpose. In addition, organic and organosilicon isolation materials such as spin-on glass formulations comprising siloxanes having $C_1$-$C_{10}$ alkane substitution, substituted silsesquioxanes having $C_1$-$C_{20}$ alkyl, aryl or alkylaryl substitution, fluoropolymers comprising tetrafluoroethylene, polyimides, and the like are suitable isolation materials.

Isolation of individual bits along, for example, a word line is accomplished using contact diode structures of the kind described and shown in Figure 5. Stacked devices in which electrodes are shared between device layers are exemplified in Figure 6. These stacked devices are distinguished in that they do not use isolation layers. Instead, the word-line is shared between adjacent field programmable film layers.

Figure 5 depicts a cutaway partially exploded view of a stacked data storage device having a substrate, 43, a first device layer and a second device layer. The first device layer comprises a vertical line array having conducting or semiconducting lines, exemplified by 44, in contact with a conducting or semiconducting material, exemplified by 45, having a different work function than 44 thus forming a contact diode, and insulators having a dielectric constant, exemplified by 47, an electric field programmable film, 46, and a horizontal line array comprising conducting or semiconducting lines, exemplified by 48 and insulators having a dielectric constant, exemplified by 49. The diode comprises

an anode comprising a metal having a work function between 2.7 and 4.9 eV and a conducting polymer having a work function greater than 4.5 eV. Portions of the bottom surface of 46 are electrically coupled to the lines, 44 via the contact diodes formed by 44 and 45. Portions of the top surface of 46 are electrically coupled to the lines, 48.

Figure 5 further depicts, in cutaway form, a second device layer, isolated from the first device layer by an isolating film, 50, having a dielectric constant. The second device layer comprises a vertical line array having conducting or semiconducting lines, exemplified by 51, in contact with a conducting or semiconducting material, exemplified by 52, having a different work function than 51 thus forming a contact diode, and insulators having a dielectric constant, exemplified by 54, an electric field programmable film, 53, and a horizontal line array comprising conducting or semiconducting lines, exemplified by 55 and insulators having a dielectric constant, exemplified by 56. Portions of the bottom surface of 53 are electrically coupled to the lines, 51 via the contact diodes formed by 51 and 52. Portions of the top surface of 46 are electrically coupled to the lines, 55. The first and second device layers in Figure 5 are shown aligned with one another but can be offset to facilitate interconnection.

In Figure 6 is provided a partially exploded cutaway view of yet another stacked data storage memory device comprising a substrate, 57, and three device layers. The first device layer comprises a vertical line array having conducting or semiconducting lines, exemplified by 58, in contact with a conducting or semiconducting material, exemplified by 59, having a different work function than 58 thus forming a contact diode, and insulators having a dielectric constant, exemplified by 61, an electric field programmable film, 60, and a horizontal line array comprising conducting or semiconducting lines, exemplified by 62 and insulators having a dielectric constant, exemplified by 63. Portions of the bottom surface of 60 are electrically coupled to the lines, 58 via the contact diodes formed by 58 and 59. Portions of the top surface of 60 are electrically coupled to the bottom sides of the lines, 62.

The second device layer in Figure 6 comprises the same horizontal line array as the first device layer, having conducting or semiconducting lines, exemplified by 62, and insulators having a dielectric constant, exemplified by 63, an electric field programmable film, 64, and a vertical line array comprising conducting or semiconducting lines, exemplified by 66, in contact with a conducting or semiconducting material, exemplified by 65, having a different work function than 66, thus forming a contact diode, and insulators having a dielectric constant, exemplified by 69. Portions of the bottom surface of 64 are electrically coupled to the top surfaces of the lines, 62. Portions of the top surface of 64 are electrically coupled to the lines, 66 via the contact diodes formed by 65 and 66. The horizontal line array, comprising the conducting or semiconducting lines, 62 and insulators, 63, is shared by the first and second device layers.

The third device layer in Figure 6 comprises a vertical line array having conducting or semiconducting lines, exemplified by 66, in contact with a conducting or semiconducting material, exemplified by 67, having a different work function than 66 thus forming a contact diode, and insulators having a dielectric constant, exemplified by 69, an electric field programmable film, 68, and a horizontal line array comprising conducting or semiconducting lines, exemplified by 70 and insulators having a dielectric constant, exemplified by 71. Portions of the bottom surface of 68 are electrically coupled to the lines, 66 via the contact diodes formed by 66 and 67. The third device layer in Figure 6 shares the electrodes exemplified by 66 with the second device layer via 67. Portions of the top surface of 68 are electrically coupled to the bottom sides of the lines, 70.

Figure 7 provides, in cutaway, contiguous, 7(a), and exploded, 7(b), views of a portion of a data storage memory device in which the memory elements are isolated by junction diodes. A p-type semiconductor, 72, is used as the substrate, with a vertical n+ bit line array, exemplified by 73, a plurality of p+ zones doped within each bit line, exemplified by 74, a patterned matrix for isolating the electric field programmable film elements, 75, electric field programmable film elements, exemplified by 76, and conducting or semiconducting word lines, 77, each in contact with a row of electric field programmable film elements. The p+ regions, 74, and the n+ bit lines, 73, form an array of isolation diodes, which electrically isolate the intended bits for reading, writing and addressing.

Addressing an individual bit in a cross-point array such as those in Figures 2 and 3 requires isolation of the selected bit from the contiguous bits as well as the bits along the same word line. In general, this isolation is effected by introducing an asymmetry in the "on" and "off" threshold voltages for the device where the magnitudes of the "on" and "off" threshold voltages differ significantly.

One method of producing such an asymmetry is by forming a inorganic oxide on one of the electrodes prior to the deposition of the electric field programmable film. This can be accomplished by allowing the metal of the electrode to form a native oxide in air or, more actively, by oxidizing the metal electrode in ozone. In this way, the two electrode surfaces are electrically coupled to the electric field programmable film in different ways; one is electrically coupled via capacitive coupling while the other is in direct contact. The oxide coating on the electrode must be sufficiently thin to enable charge injection into the electric field programmable film via tunneling, hot carrier injection or electron hopping. For example, with aluminum oxide, thicknesses of 0.5 to 3.0 nm are used.

Another method of producing such an asymmetry is by using metals with differing work functions. The work function is defined as that energy required to remove an electron from the surface of the metal to infinity. While different crystal faces of metals and other elements exhibit different work functions, the electrodes used on the electric field programmable films are polycrystalline. Accordingly, the work function comprises an average of the crystalline forms in

contact with the electric field programmable film. By way of example, consider an electric field programmable film in contact with an aluminum electrode on one side (Φ~ 4.2 electron-volts (eV)) and a nickel electrode on the other (Φ~ 5.2 eV). If the forward bias is defined as proceeding from the aluminum electrode to the nickel electrode, with the aluminum electrode being the anode, the magnitude of the forward bias voltage required to initiate the "on" state will be higher than the magnitude of the reverse bias voltage required to impose the "off" state. Among the transition elements, Al, Cr, Fe, Re, Ru, Ta, Ti, V, W and Zr all exhibit work functions less than 5 eV, Rh exhibits a work function of approximately 5 eV and Au, Cu, Ir, Ni, Pd, and Pt exhibit work functions greater than 5 eV.

Still another way to impose asymmetry on devices comprising field programmable films is to introduce contact diodes using organic conductors and semiconductors. Such diodes are described in L. S. Roman and O. Inganäs, Synthetic Metals, 125, (2002), 419 and can be further understood by making reference to Figures 2(b) and 5. In brief, these diodes comprise a low work function conducting polymer such as poly(3-(2'-methoxy-5'-octylphenyl)thiophene) (POMeOPT) (Φ ~ 3 eV) in contact on one side with an Al electrode (Φ ~ 4.2 eV) and on the other side with poly(3,4-ethylenedioxythiophene) doped with poly(4-styrenesulfonate) (PEDOT - PSS) (Φ ~ 5.2 eV), which, in turn, is in contact with an aluminum electrode. In the device POMeOPT is interposed between the electric field programmable film and the metal electrode. Aluminum or some other metal having a similar work function electrode such as copper <1 10> (Φ ~ 4 5 eV) is applied to the opposite side of the electric field programmable film. Other organic conductors and semiconductors that are used in this invention are doped polyaniline, doped polypyrrole, polythiophene, and polyphenylene vinylene. In addition, one can use indium-tin-oxide (ITO) to introduce an asymmetry in the "on" and "off" voltages in like manner to the above examples.

Still another way to introduce an asymmetry in the "on" and "off' voltages is to place the device in contact with a semiconductor diode of the kind shown in Figure 7. Yet another way to isolate the "on" and "off" voltages is to place the device in electrical contact with a field effect isolation transistor. This can be effected such that the field programmable film is electrically coupled to the source or the drain of the transistor either via a metal "plug" electrode or directly, such that the device can only be probed or programmed when the gate in an "open" condition.

In a memory or data storage mode, programming, reading and erasing the memory cell can be accomplished by pulsing the cell above the threshold voltage to place it in the "on" condition, pulsing at a sub-threshold voltage to read the cell to determine whether it is "on" or "off" and pulsing the cell at a sufficiently negative voltage to turn the cell "off." In addition, it has been found that the cell can be turned "off" by pulsing at a sufficiently positive voltage above a second positive voltage threshold, thus avoiding the need for a negative pulse.

In a different application, the field programmable film described herein can be used as a medium for mass data storage. In one embodiment, the field programmable film has a thickness of 5 to 500 nm. In one embodiment the field programmable film has a thickness of 10 to 200 nm. In yet another embodiment, the field programmable film has a thickness of 10 and 100 nm. The film is disposed on a conducting or semiconducting substrate. Examples of semiconducting substrates are doped silicon wafers, silicon carbide, silicon germanium, silicon on silicon germanium, gallium arsenide, indium gallium arsenide, gallium nitride, gallium phosphide, gallium antimonide, indium arsenide, indium nitride, indium phosphide, cadmium sulfide, cadmium selenide, cadmium telluride, zinc oxide, zinc sulfide, zinc selenide, zinc telluride, lead sulfide, lead telluride, aluminum arsenide, aluminum nitride, aluminum phosphide, aluminum antimonide, boron nitride, boron phosphide, germanium, or any semiconductor material with a band gap between about 0.05 eV and about 2.5 eV while examples of conductive substrates are aluminum, titanium, vanadium, chromium, manganese, iron, cobalt, nickel, copper, zinc, zirconium, niobium, molybdenum, ruthenium, rhodium, palladium, silver, cadmium, hafnium, tantalum, tungsten, rhenium, osmium, iridium, platinum, gold mercury, tin, germanium, lead, or the like, or a combination having at least one of the foregoing.

In one embodiment, the data storage is achieved by applying an alternating current (AC), direct current (DC), or DC biased AC electrical signal of sufficient amplitude to drive the film into the conductive or on state. The electrical signal is usually about -10 V to about 10 V, using a conducting tip such as that used in scanning probe microscopy. If an AC signal is used, the AC signal is about 0.5 kHz to about 100 MHz, usually about 10 kHz to about I MHz. The field can be applied by the tip in contact mode or non contact mode and results in a conductive domain within the field programmable film having a diameter of about 0.5 nm to about 500 nm and more frequently having a diameter of about 0.5 to about 50 nm. The domain can be read by a scanning force microscope tip using an AC, DC or DC biased AC signal of about -10 V to about 10 V in either contact or non contact mode while monitoring current, impedance, voltage drop, capacitance, tapping phase shift or any combination of the forgoing. In addition, the field programmable film can be written, erased or read by optical means or a combination of optical means and one or more of the forgoing electrical signals. The size of the conductive domain can be optimized for the desired application. For example, domains that are readable with a scanning probe microscope tip can be about 1 nm to about 100 nm while domains readable with a laser probe such as might be found in a CD player can have diameters of about 100 nm to about 500 nm. In this way, the field programmable film can be programmed in configurations where at least one of the electrodes is not held in a fixed position relative to the surface of the field programmable film. An example of an apparatus for storing information in this way is set forth in patent application WO02/077986.

Memory devices such as those detailed above may be used in a variety of applications, including any application where conventional memory devices are employed. In one embodiment, the non-volatile polymer memory is integrated with conventional volatile memory such as SRAM, DRAM or other volatile memory. This may be done in a variety of ways, including packaging one or more conventional memory devices with one or more memory devices that contain the electric field programmable film. Alternatively a memory device containing the electric field programmable film may be integrated on a single chip with one or more types of conventional memory devices. For example, cell phones, or the like, use volatile SRAM or DRAM as execution memory and nonvolatile FLASH as memory for code and data storage. Thus, in cell phones, often a DRAM or SRAM chip is packaged with a FLASH chip and sold as a single unit. The electric field programmable film can be used in a memory device that can replace FLASH in the cell phone application, either as one electric field programmable memory device chip in a multichip package or as an electric field programmable memory device integrated onto a conventional (e.g. DRAM, SRAM) chip. The electric field programmable film memory devicemay be used as non-volatile memory, backing store, or shadow RAM. In alternate embodiments, the memory device containing the electric field programmable film may be integrated or packaged with PROM, EPROM or other substantially read-only memory. In these embodiments, the memory device containing the electric field programmable film serves as the modifiable, working, or execution memory because it is read/write capable. Further embodiments include integration of the memory device containing the electric field programmable film with other non-volatile memories to provide functionality that compliments the other non-volatile memory; for example integration with EEPROM, FLASH, FeRAM or MRAM. Another embodiment is the integration of electric field programmable film memory element into a conventional memory element circuit to provide permanent storage of state information.

In another embodiment, the memory device containing the electric field programmable film may be integrated with logic rather than with other types of memory. In a first example of a memory device containing the electric field programmable film integrated with logic, the memory device is used as a memory array integrated on the logic chip. This may allow fabrication of memory on a chip at locations not previously achievable with conventional memory types, for example embedded at the M1 or higher levels above the logic chip. It also increases memory size as compared with conventional memories. Locating memory directly on the chip improves the memory access speed, since pin/wiring latencies are avoided, and lowers cost by reducing chip count and packaging cost. The memory device containing the electric field programmable film may be used as on-chip cache to increase cache size while keeping silicon area down, and simultaneously bringing non-volatility to the cache. Exemplary applications of such uses of integration of memory devices containing the electric field programmable film with logic would be as memory arrays, buffers, latches, and registers in SOC and CPU applications, or the like.

The integration of logic with a memory device containing the electric field programmable film provides a technique to integrate a controller, interface, or memory-supporting functions onto a memory chip, reducing latency and/or cost. Exemplary logic functions that may be integrated on the memory device include hypertransport protocol logic or a memory controller e.g. for a high performance memory unit; a cache controller or a crossbar switch e.g. for a high performance cache; interfaces such as a network or bus interface e.g. for network storage appliances, IO interfaces, DMA controllers, or routers; a video interface, e.g. for RAMDAC or video memory; integrated controllers such as an integrated USB controller and firmware device drivers for a USB "Thumb drive"; memory management or lookup logic such as a translation lookaside buffer, a page frame table for a translation lookaside buffer; a segment lookaside buffer. It is understood that other components may be integrated on-chip by using the memory device containing the electric field programmable film.

Memory devices containing the electric field programmable film may also be integrated with a supporting logic circuit at the logic cell level as well as at higher levels. Such an integration provides a reconfigurable logic unit in which the connectivity, state or function of the logic unit is controlled or defined by the state of the memory device. Such devices include programmable logic arrays (PLA) or field programmable gate arrays (FPGA). Further, a memory device containing the electric field programmable film may serve as part of a content addressable memory unit.

Embodiments of the memory device containing the electric field programmable film may be used to support a wide variety of data structures. The memory device may also be used to implement, store, display, transmit, or process data structures. Such data structures include Boolean, byte, integer (signed and unsigned), floating point, character; character string; composite types (e.g., made of primitives); scalars, pointers, vectors, matrices; object oriented descriptors such as subtype and derived type object based descriptors; ordered tables, linked lists, queues, heaps and stacks; binary and higher ordered trees; hash tables; relational databases and their keys; graphs, or the like.

The memory device containing the electric field programmable film may also be utilized in complex machines and serve as a storage element, part of a processor, or both. One application of the polymer memory is within a Turing machine or Universal Turing Machine. The polymer memory may be included in a state machine such as a finite state machine, Moore machine, Mealy machine, Rabin or Buchi automaton, or tree automaton. The polymer memory may be included in a neural network such as a single or multilevel perceptron machine, recurrent network, Hopfield network, Boltzmann machine, Kohonen Map, or Kak network. The polymer memory may be included in a von Neumann architecture machine (shared data and code) or a Harvard architecture machine (separate data and code). This would be seen to include architectures of parallel computers actually implemented as clusters of von Neumann elements. The memory

device may also be included in the implementation of parallel, non-sequential, non-deterministic, or dataflow-based processing computer architectures.

A variety of types of computing devices may utilize a memory device containing the electric field programmable film. One way to define different classes of computing devices is through mathematical rules known as grammars. For example, a machine may be classified as recognizing a language generated by a type 3 grammar; such a machine would be defined as corresponding to a type 3 grammar. Exemplary machines in this class include a deterministic finite state machine (or automaton), including a Moore Machine, a Mealy Machine, a Rabin Automaton, a Buchi Automaton, a Streett automaton, or a tree automaton. A machine may be classified as recognizing a language generated by a type 2 grammar or which corresponds to a type 2 grammar. Exemplary machines in this class include a counting automaton and a deterministic or non-deterministic pushdown automaton.

A machine may be classified as recognizing a language generated by a type 0 or I grammar or which corresponds to a type 0 or 1 grammar. Exemplary machines in this class include a linear bounded automaton, a Turing Machine or Universal Turing Machine, a Turing Machine with more than one "tape" or a "tape" of more than one dimension.

Machines utilizing the memory device containing the electric field programmable film may also be classified based on the instruction and data processing architecture. A machine may be a single instruction, single data machine such as a von Neumann architecture machine or a Harvard architecture machine. A machine may be a single instruction, multiple data machine, such as a processor in memory machine or a vector or array processor. A machine may be a multiple instruction, multiple data machine, such as a dataflow-based processor or other non-deterministic processor. A machine may be a multiple instruction, single data machine. Processors in such machines may use known binary representations such a bits, or representations having more than two discrete values, including such alternative representations as qubits, or the like.

The memory device may be utilized in a system comprising a hybrid of one or more of the above types, for example a hyperthreading or instruction-level-parallel (ILP) von Neumann architecture which combines aspects of the dataflow processor with the von Neumann architecture, or an implementation of a MIMD machine using multiple von Neumann machines. Such combinations of machines may operate sequentially, in parallel, or as a composite.

The memory device may also be used in less complex components such as counters, buffers, registers, or the like. The memory device may be used in consumer products such as cell phones, personal digital assistants (PDAs), set top boxes, or the like. Further, the memory device may be used in complex computer systems such as multi-processor servers.

The electric field programmable film has numerous advantages over other films in which the electron donors and/or the electron acceptors and/or the donor-acceptor complexes are not bonded to the polymer. For example, volatile electroactive moieties will not remain in the film during baking. This makes it difficult to control the composition of the field programmable film, particularly at thicknesses below 500 nm. For acceptor materials such as 8-hydroxyquinoline, pentafluoroaniline, dimethyl anthracene and the like, as thicknesses approach about 100 nm, bake temperatures of less than 100°C are desirable to avoid virtually compiete loss of the acceptor material. In addition, the bake time is generally about 30 minutes. Such long bake times are required to remove a significant portion of the casting solvent at low temperatures. Volatilized solid materials also contaminate the coating equipment by forming thin film or crystalline deposits. Such contamination contributes significantly to particle-induced defects in semiconductor devices.

The electric field programmable film, when crosslinked, is thermally and dimensionally stable at elevated temperatures of 120 to 250°C. In another embodiment, the electric field programmable film is thermally and dimensionally stable at elevated temperatures of 150 to 200°C. Further, subsequent processing steps required to fabricate devices can be carried out without damaging the field programmable film. Such steps include solvent based photoresist application, etching, sputter coating, vacuum evaporation, adhesion promotion, chemical mechanical polishing, the application of another field programmable film, and the like.

Some embodiments of the invention will now be described in detail in the following Examples. In the formulation examples all weight percents are based on the total weight of the electric field programmable film composition unless otherwise expressed.

EXAMPLES

Example 1

This example demonstrates the synthesis of gold nanoparticles used as electron donors. Gold nanoparticles were synthesized at room temperature using a two-phase arrested growth method detailed by M. J. Hostetler, et. al., Langmuir, 14 (1998) 17. In a typical synthesis, an aqueous solution containing 0.794 grams (g) (2 millimole (mmol)) of tetrachloroauric acid ($HAuCl_4.3H_2O$), in 50 milliliters (ml) of water was added to an 80 ml toluene solution containing 3.0g (5.5 mmol) of tetraoctylammonium bromide. The mixture was stirred vigorously for I hour. To the separated toluene solution was added 0.81 g (4 mmol) of dodecane thiol (DSH). The resulting mixture was stirred for 10 minutes at room

temperature. A 50 ml aqueous solution of sodium tetrahydridoborate ($NaBH_4$) (20 mmol) was then added to the mixture over a 10 second period with vigorous stirring and the resulting mixture was further stirred for 1 hour at room temperature. The dark colored toluene phase was collected, washed with water using a separatory funnel and reduced in volume by approximately 90% under vacuum. Once the toluene solution was reduced, the gold nanoparticles were precipitated by mixing with 20 to 40 milliliters of ethanol and separated using a centrifuge. The product was then washed several times altematingly with ethanol and then with acetone and dried in vacuum. This procedure yielded gold nanoparticles having a radius of gyration of approximately 1.37 nanometers (nm) in hexane solvent, as measured by low angle x-ray scattering.

Examples 2-18

Different sized nanoparticles were obtained by varying the temperature of reduction during the addition of $NaBH_4$ solution and subsequent stirring. Different sized nanoparticles were also obtained by varying the addition time of the $NaBH_4$ solution or the molar ratio of DSH to $HAuCl_4$-$3H_2O$. Results are summarized in Table 2 below.

Table 2

| Example | DSH/Au Molar ratio | Temperature(°C) | $NaBH_4$ addition time (sec) | radius of gyration (nm) |
|---|---|---|---|---|
| 2 | 0.2 | 20 | 10 | 1.7 |
| 3 | 1.1 | 20 | 10 | 1.29 |
| 4 | 2 | 20 | 255 | 1.36 |
| 5 | 2 | 20 | 500 | 1.37 |
| 6 | 2 | 20 | 500 | 1.41 |
| 7 | 2 | 55 | 10 | 1.32 |
| 8 | 2 | 55 | 206 | 1.35 |
| 9 | 0.2 | 55 | 206 | 1.95 |
| 10 | 1.28 | 55 | 500 | 1.34 |
| 11 | 2 | 90 | 10 | 1.34 |
| 12 | 0.2 | 90 | 10 | 2.16 |
| 13 | 1.1 | 90 | 10 | 1.44 |
| 14 | 1.1 | 90 | 255 | 1.39 |
| 15 | 0.2 | 20 | 500 | 1.99 |
| 16 | 0.2 | 90 | 500 | 2.73 |
| 17 | 2 | 90 | 500 | 1.33 |
| 18 | 2 | 90 | 255 | 1.31 |

Example 19

This example demonstrates the synthesis of 9-anthracenemethyl methacrylate. A two liter, 3-necked round bottomed flask was equipped with a condenser, dropping addition funnel, mechanical stirrer, and gas inlet tube. The flask was charged with 9-anthracenemethanol (48.9grams, 0.235 mol) and purged with nitrogen for 10 minutes. Anhydrous tetrahydrofuran (300 ml), pyridine (33 mL), and triethylamine (50 mL) were added to the flask, and the resulting solution was cooled to 0°C. Methacryloyl chloride (technical grade, 37.5 ml, 40.1grams, 0.345 mol) was added using a syringe into the addition funnel, and added slowly dropwise to the vigorously stirring solution over the course of I hour. A brownish precipitate formed and aggregated into a gummy mass, which periodically interfered with stirring. The reaction was kept at a temperature of 0°C for 2 hours and was then allowed to gradually warm up to room temperature overnight. The reaction was quenched with water (400 ml). Ethyl ether (300 ml) was added to the flask, and the phases were separated in a two liter separatory funnel. The organic phase was washed successively with 20% aqueous hydrochloric (HCl) (400 ml), saturated aqueous sodium bicarbonate ($NaHCO_3$) (800 ml), and saturated aqueous sodium chloride (NaCl) (400 ml). The organic phase was dried over sodium sulfate ($Na_2SO_4$), filtered, and the solvent was removed in vacuo. The resulting crude product was recrystallized in two batches using methanol (MeOH) (400 ml).

Example 20

This example demonstrates the synthesis of methacrylate. A typical synthesis was carried out in a similar manner to example 19 except that 8-hydroxyquinoline (34.1 grams, 0.235 mol) was used in place of 9-anthracenemethanol.

Example 21

This example demonstrates the synthesis of 9-anthracenemethyl methacrylate/2-hydroxyethyl methacrylate copolymer. A 500 ml, 3-necked round bottom flask was fitted with a condenser and gas inlet tube and purged with nitrogen for 15 minutes. The flask was then charged with 120 ml of degassed tetrahydrofuran (THF), 9-anthracenemethyl methacrylate (ANTMA) (10.0 grams, 36.2 mmol) and 2-hydroxyethyl methacrylate (HEMA) (9.3 ml, 10.0 grams, 76.8 mmol). To this mixture was added 1,1'-azobis-(cyclohexane carbonitrile) (commercially available from Du Pont as VAZO 88) (0.57 grams, 2.33 mmol, 2.85 % w/w), and the solution was heated to reflux. After 24 hours, an additional portion of VAZO 88 initiator (0.89 grams, 3.64 mmol, 4.45 % w/w) was added, and the mixture was refluxed for another 24 hours. The reaction was then cooled to room temperature and the THF solution was poured into 500 ml of a hexane/ethyl ether solution containing 20 volume percent of hexane in ethyl ether to precipitate the polymer. The solid polymer was collected by suction filtration and dried *in vacuo* to yield 19.5 g (98%) as a fluffy white solid.

Example 22

This example demonstrates the synthesis of quinolin-8-yl methacrylatel2-hydroxyethyl methacrylate copolymer. This synthesis is carried out in a manner similar to that of Example 21 except that quinolin-8-yl methacrylate (7.71 grams, 36.2 mmol) is added in place of 9-anthracenemethyl methacrylate.

Example 23

This example demonstrates the synthesis of 9-anthracenemethyl methacrylate/2-hydroxyethyl methacrylatel3-(trimethoxysilyl)propyl methacrylate terpolymer. In this synthesis a 500 ml, round bottomed sidearm flask (the "reactant reservoir") was charged with propylene glycol methyl ether acetate (PGMEA) (117.5 grams), 9-anthracenemethyl methacrylate (46.0 grams, 166 mmol), 2-hydroxyethyl methacrylate (6.82 grams, 52.4 mmol), 3-(trimethoxysilyl)propyl methacrylate (22.2 grams, 89.4 mmol) and t-amyl peroxy pivalate (7.5 grams, 39.8 mmol). The flask was fitted with a rubber septum cap. An outlet tube, connected to an electronically controlled pump was inserted through the septum cap. A I liter, 3-neck flask with bottom valve (the "reaction vessel") was equipped with a heating mantle, a rheostat (variac), a Friedrich's condenser, a mechanical stirrer, a claisen head, a thermal probe (thermocouple connected to an power controller) and a nitrogen inlet. The flask was charged with PGMEA (275 grams) and the temperature was then raised to 85°C and allowed to equilibrate. The above described monomer-initiator solution was fed from the reactant reservoir into the reaction vessel at a reactant feed rate of approximately 1.69 ml/min using an electronically controlled pump (manufactured by SciLog), previously calibrated for flow rate with PGMEA, such that a total reactant feed time of about 120 minutes is achieved. Upon completion of the feed, the reaction was stirred at the temperature of 85°C for 30 minutes, at which time degassed t-amyl peroxy pivalate (7.5 grams, 27.5 mmol) and PGMEA (25 grams) was fed into the reaction at a rate of about 1.14 ml/minute. The degassed t-amyl peroxy pivalate and PGMEA was fed in as a chase and is fed into the reactor for 30 minutes. After the feeding of the degassed t-amyl peroxy pivalate and PGMEA was complete, the reaction was stirred at the temperature of 85°C. for an additional hour, then cooled to room temperature and transferred to a suitable container.

Example 24

This example was undertaken to synthesize quinolin-8-yl methacrylate/2-hydroxyethyl methacrylate/3-(trimethoxysilyl)propyl methacrylate terpolymer. A typical synthesis was carried out in a manner similar to that of Example 23 except that quinolin-8-yl methacrylate (35.4 grams, 166 mmol) was added in place of 9-anthracenemethyl methacrylate and the reactant feed rate was about 1.60 ml/min such that the total time of addition was 120 minutes.

Example 25

The formulation for this example was prepared by reacting the 9-anthracenemethyl methacrylate/2-hydroxyethyl methacrylate copolymer obtained from Example 21 (0.3 grams) with the gold nanoparticles from Example 1 (0.075 grams) and a 50/50 w/w blend of methoxybenzene and 2-heptanone (14.63 grams). The formulation was agitated

overnight on a laboratory roller to dissolve the components, sonicated in an ultrasonic bath for 10 minutes and filtered through a 0.2 micrometer membrane filter. A test memory cell was fabricated by spin coating the formulation on a silicon wafer having a diameter of 100 millimeters. The silicon wafer was a p-type wafer having a resistivity of about 0.0001 to about 0.1 ohm-cm. The silicon wafer was then baked on a hotplate at 110°C for 60 seconds to give a film having a thickness of about 20 to about 100 nm. The average thickness was about 50 nm. Aluminum dots of about 0.5 mm in diameter and about 45 nm of thickness were then evaporated thermally on top of the film through a shadow mask at a pressure of about $10^{-6}$ to $5 \times 10^{-5}$ torr Current-voltage characteristics were measured using a Keithley 6517A electrometer with the silicon wafer configured as a ground terminal and the aluminum electrode configured as a working electrode. The entire measurement was controlled using LabView software (Digital Instruments Corp.) that was initially programmed to sweep from 0.0 V to about 7.0 V, from a 7.0 V to 0.0 V and from 0.0 to -7.0 V. The voltage range was then adjusted to avoid overdriving the cell during the positive and negative voltage sweeps. The currents in the off state were generally less than or equal to about 10 nanoamperes (nA) while typical currents in the on state were greater than or equal to about 1 microamperes (μA).

Example 26

The formulation of this example is prepared by combining the 9-anthracenemethyl methacrylate/2-hydroxyethyl methacrylate copolymer from Example 21 (0.3 grams) with gold nanoparticles from Example 1 (0.101 grams), 1,3,4,6-tetrakis(methoxymethyl) tetrahydroimidazo[4,5-d]imidazole-2,5-dione (0.101 grams), p-toluenesulfonic acid solution (1% w/w p-toluenesulfonic acid solution in 50/50 w/w blend of methoxybenzene and 2-heptanone, 0.201g) and a 50/50 w/w blend of methoxybenzene and 2-heptanone (16.1 grams). The formulation is agitated overnight on a laboratory roller to dissolve the components, sonicated in an ultrasonic bath for 10 minutes and filtered through a 0.2 micrometer membrane filter. A test memory cell using the formulation of this example is fabricated and tested as in Example 25 except that the polymer-based film is baked a second time on a hotplate at 200° C for 60 seconds.

Example 27

The formulation for this example is prepared by combining the quinolin-8-yl methacrylate/2-hydroxyethyl methacrylate copolymer from Example 22 (0.3 grams) with gold nanoparticles from Example 1 (0.075 grams) and a blend of methoxybenzene and 2-heptanone (14.63 grams). The methoxybenzene and 2-heptanone are mixed in a ratio of 1: 1. The formulation is agitated overnight on a laboratory roller to dissolve the components, sonicated in an ultrasonic bath for 10 minutes and filtered through a 0:2 micrometer membrane filter. A test memory cell using the formulation of this example is fabricated and tested in a manner similar to that in Example 25.

Example 28

The formulation of this example is prepared by combining the quinolin-8-yl methacrylate/2-hydroxyethyl methacrylate copolymer from example 22 (0.3 grams) with gold nanoparticles from Example 1 (0.101 grams), 1,3,4,6-tetrakis (methoxymethyl) tetrahydroimidazo[4,5-d]imidazole-2,5-dione (0.101 grams), p-nitrobenzyl tosylate solution (0.201 grams) (the p-nitrobenzyl tosylate solution comprised I wt% of p-nitrobenzyl tosylate in a 1:1 mixture of methoxybenzene and 2-heptanone) and a 1:1 mixture of methoxybenzene and 2-heptanone (16.1 grams). The formulation is agitated overnight on a laboratory roller to dissolve the components, sonicated in an ultrasonic bath for 10 minutes and filtered through a 0.2 micrometer membrane filter. A test memory cell using the formulation of this example is fabricated and tested in a manner similar to that described in Example 25, except that the polymer-based film is baked a second time on a hotplate at 200° C for 60 seconds.

Example 29

The formulation for this example was prepared by combining the 9-anthracenemethyl methacrylate/2-hydroxyethyl methacrylate/3-(trimethoxysilyl)propyl methacrylate terpolymer from Example 23 in a solution with PGMEA (2.0 g of the solution) with gold nanoparticles from Example 1 (0.075 grams) and a 1:1 blend by weight of methoxybenzene and 2-heptanone (12.93 grams). The formulation was agitated overnight on a laboratory roller to dissolve the components, sonicated in an ultrasonic bath for 10 minutes and filtered through a 0.2 micrometer membrane filter. A test memory cell using the formulation of this example was fabricated and tested as in Example 25, except that the polymer-based film was baked a second time on a hotplate at 200°C for 60 seconds.

Examples 30-46

The formulation for each of these examples was prepared by combining 2.0 grams of a solution of 9-anthracenemethyl methacrylate/2-hydroxyethyl methacrylate/3-(trimethoxysilyl)propyl methacrylate terpolymer from Example 23 with gold nanoparticles (from Examples 2-18) and a 1:1 mixture by weight of methoxybenzene and 2-heptanone in such a way as to provide a roughly equal number of nanoparticles weighted by size as shown in the Table 3. The solution of 9-anthracenemethyl methacrylate/2-hydroxyethyl methacrylate/3-(trimethoxysilyl)propyl methacrylate terpolymer comprised 15 wt% of 9-anthracenemethyl methacrylate/2-hydroxyethyl methacrylate/3-(trimethoxysilyl)propyl methacrylate terpolymer in PGMEA.

Table 3

| Example | Nanoparticle Example | Radius of Gyration (nm) | Nanoparticle Weight (g) | Solvent Added (g) |
|---|---|---|---|---|
| 30 | 2 | 1.7 | 0.1363 | 12.68 |
| 31 | 3 | 1.29 | 0.0636 | 10.18 |
| 32 | 4 | 1.36 | 0.0735 | 10.52 |
| 33 | 5 | 1.37 | 0.0750 | 10.58 |
| 34 | 6 | 1.41 | 0.0812 | 10.79 |
| 35 | 7 | 1.32 | 0.0677 | 10.33 |
| 36 | 8 | 1.35 | 0.0720 | 10.47 |
| 37 | 9 | 1.95 | 0.2002 | 14.87 |
| 38 | 10 | 1.34 | 0.0706 | 10.42 |
| 39 | 11 | 1.34 | 0.0706 | 10.42 |
| 40 | 12 | 2.16 | 0.2671 | 17.17 |
| 41 | 13 | 1.44 | 0.0860 | 10.95 |
| 42 | 14 | 1.39 | 0.0781 | 10.68 |
| 43 | 15 | 1.99 | 0.2120 | 15.28 |
| 44 | 16 | 2.73 | 0.5195 | 25.84 |
| 45 | 17 | 1.33 | 0.0691 | 10.37 |
| 46 | 18 | 1.31 | 0.0663 | 10.28 |

Each formulation was agitated overnight on a laboratory roller to dissolve the components, sonicated in an ultrasonic bath for 10 minutes and filtered through a 0.2 micrometer membrane filter. A test memory cell using the formulation of this example was fabricated and tested as in Example 25 except that the polymer-based film was baked a second time on a hotplate at 200°C for 60 seconds.

Example 47

2.0 grams of the quinolin-8-yl methacrytate/2-hydroxyethyl methacrylate/3-(trimethoxysilyl)propyl methacrylate terpolymer of Example 24 in a solution of PGMEA was combined with gold nanoparticles from Example 1 (0.075 grams) and a 1:1 mixture by weight of methoxybenzene and 2-heptanone (12.93 grams). The quinolin-8-yl methacrylate/2-hydroxyethyl methacrylate/3-(trimethoxysilyl)propyl methacrylate terpolymer comprised 15 wt% of the solution in PGMEA. The formulation was agitated overnight on a laboratory roller to dissolve the components, sonicated in an ultrasonic bath for 10 minutes and filtered through a 0.2 micrometer membrane filter. A test memory cell using the formulation of this example was fabricated and tested as in Example 25 except that the polymer-based film was baked a second time on a hotplate at 200°C for 60 seconds.

Example 48

2.0 grams of a solution comprising 15wt% of the 9-anthracenemethyl methacrylate/2-hydroxyethyl methacrylate/3-(trimethoxysilyl)propyl methacrylate-terpolymer of Example 23 in PGMEA was combined with ferrocene (0.075 grams) and a 1:1 mixture by weight of methoxybenzene and 2-heptanone (12.93 grams). The formulation was agitated overnight on a laboratory roller to dissolve the components and filtered through a 0.2 micrometer membrane filter. A test memory cell using the formulation of this example was fabricated and tested in a manner similar to that in Example 25 except that the polymer-based film was baked a second time on a hotplate at 200°C for 60 seconds. The on-current ($I_{ON}$) current for this formulation was greater than or equal to about 10 μA.

Example 49

2.0 grams of a solution comprising 15wt% of the 9-anthracenemethyl methacrylate/2-hydroxyethyl methacrylate/3-(trimethoxysilyl)propyl methacrylate terpolymer of Example 23 in PGMEA was combined with 4,4',5,5'-bis(pentamethylene)tetrathiafulvalene (0.137 grams) and a 1:1 mixture of methoxybenzene and 2-heptanone (12.44 grams). The formulation was agitated overnight on a laboratory roller to dissolve the components and filtered through a 0.2 micrometer membrane filter. A test memory cell was fabricated by spin coating the formulation on a silicon wafer having a diameter of 100 millimeters. The silicon wafer was a p-type wafer having a resistivity of about 0.0001 to about 0.1 ohm-cm. The silicon wafer was then baked on a hotplate at 110°C for 60 seconds to give a film having a thickness of about 20 to about 100 nm. The average thickness was about 50 nm. Aluminum dots of about 0.5 mm in diameter and about 45 nm in thickness were then evaporated thermally on top of the film through a shadow mask at a pressure of about $10^{-6}$ to 5 x $10^{-5}$ torr. Current-voltage characteristics were measured using a Keithley 6517A electrometer with the silicon wafer grounded and the aluminum electrode configured as the working electrode. The entire measurement was controlled by LabView software commercially available from Digital Instruments Corporation, and programmed initially to sweep from 0.0 V to about 7.0 V, from a 7.0 V to 0.0 V and from 0.0 to -7.0 V. The voltage range was then adjusted to avoid overdriving the cell during the positive and negative voltage sweeps.

Example 50

The formulation of this example was prepared by combining the 9-antitracenemethyl methacrylate/2-hydroxyethyl methacrylate/3-(trimethoxysilyl)propyl methacrylate terpolymer from Example 23 with gold nanoparticles from Example 1 (0.075 grams). The terpolymer from Example 3 was first mixed with PGMEA to form a first solution comprising 15 wt% of the terpolymer. 2.0 grams of the first solution was then mixed with the gold nanoparticles from Example 1 in a solvent consisting of a 1:1 mixture of methoxybenzene and 2-heptanone (12.93 grams) to form a second solution. The second solution was agitated overnight on a laboratory roller to dissolve the components, sonicated in an ultrasonic bath for 10 minutes and filtered through a 0.2 micrometer membrane filter. A test memory cell was fabricated by spin coating the second solution on a silicon wafer having a diameter of 100 mm. The silicon wafer was a p-type wafer having a resistivity of about 0.0001 to about 0.1 ohm-cm. The wafer was baked on a hotplate at 120° C for 60 seconds to give a film thickness of about 20 to about 100 nm. The average film thickness was about 50 nm. Aluminum dots of about 0.5 mm in diameter and about 45 nm of thickness were then evaporated thermally on top of the film through a shadow mask at a pressure of about $10^{-6}$ to 5 x $10^{-5}$ torr. Current-voltage characteristics were measured using a Keithley 6517A electrometer with the silicon wafer configured as the ground and the aluminum electrode configured as the working electrode. The entire measurement was controlled by LabView (available from National Instruments corporation) software and was programmed initially to sweep from 0.0 V to about 7.0 V, from 7.0 V to 0.0 V and from 0.0 to-7.0 V. The voltage range was then adjusted to avoid overdriving the cell during the positive and negative voltage sweeps. Currents in the 'off' state were below about 10 nA while currents in the 'on' state were above about 1 μA. The cell was pulsed at about 6 V for 100 milliseconds and then pulsed repeatedly at 4 V and a 100 millisecond pulse width while measuring the 'on' current. The voltage was turned off for 100 milliseconds after each 4 V pulse. No significant degradation of the 'on' current was observed after about 7000 pulses.

Example 51

The formulation for this example was prepared in a manner similar to that of Example 50. The formulation was tested in a manner similar to that in Example 50. The cell was pulsed at about 6 V for 100 milliseconds and then the cell was repeatedly stressed in the 'on' state using a 0 to 3 V sinusoidal wave of about 5 Hz. The 'on' current is measured after about every 1000 cycles. No significant degradation of the 'on' current is observed after about 5 X $10^7$ cycles.

Example 52

The test cell is fabricated and tested as in Example 51 except that the cell is repeatedly stressed in the 'on' state using a 0 to 4 V trapezoidal wave having a rise time of 30 μs, a 4 V constant voltage time of 30 μs, a fall time of

30 μs and an off time of 90 μs (about 5.556 kHz). The 'on' current is measured after about every 1000 cycles. Field programmable devices can be damaged by abrupt changes in voltage. Such rapid increases in voltage can be described as a Fourier series whose terms are decreasing in amplitude with increasing multiples of the fundamental frequency. The Fourier series for a square wave, for example, converges more slowly than the Fourier series for a trapezoidal wave having voltage ramps. For a given amplitude, the high frequency components of a square wave have a greater amplitude than those of a trapezoidal wave. The capacitive reactance of a field programmable device is inversely proportional to frequency. Therefore, a high frequency Fourier component will tend to force current through the device at a ration that is roughly proportional to its amplitude. Accordingly, programming or reading a field programmable device with a longer rise time signal such as might be seen in a trapezoidal wave will reduce the current forced through the device and reduce device fatigue.

Example 53

The formulation for this example is prepared by blending the formulation of Example 35 with the formulation of Example 44 in a 1:1 ratio by weight. The blended formulation is agitated for 20 minutes on a laboratory roller and filtered through a 0.2 micrometer membrane filter. A test memory cell is fabricated by spin coating the formulation of the present example on a 100 millimeter (mm) silicon wafer and baked on a hotplate at 110° C for 60 seconds and baked a second time on a hotplate at 200° C for 60 seconds to give a film thickness of about 20 to about 100 nm. The average film thickness is about 50 nm. Aluminum dots of about 0.5 mm in diameter and about 45 nm of thickness are then evaporated thermally on top of the film through a shadow mask at a pressure of about $10^{-6}$ to 5 x $10^{-5}$ torr. Current-voltage characteristics are measured using a Keithley 6517A electrometer with the silicon wafer configured as the ground and the aluminum electrode configured as the working electrode. The entire measurement is controlled by LabView software programmed initially to sweep from 0.0 V to about 7.0 V, from a 7.0 V to 0.0 V and from 0.0 to -7.0 V. The voltage range is then adjusted to avoid overdriving the cell during the positive and negative voltage sweeps.

Example 54

The formulation for this example is prepared by blending the formulation of Example 29 with the formulation of Example 47 in a 1:1 ratio by weight. The blended formulation is agitated for 20 minutes on a laboratory roller and filtered through a 0.2 micrometer membrane filter. A test memory cell using the formulation of this example is fabricated and tested as in Example 53.

Examples 55-58

These examples were undertaken to demonstrate the synthesis of polyester binders having acceptor moieties. In all cases, the reagents were initially charged into the reactor with little regard to the order of addition. The reaction setup consisted of either a 100 milliliter or a 250 milliliter three-neck, round-bottom flask fitted with a mechanical stirrer, temperature control box, temperature probe, heating mantle, condenser, Dean-Stark trap, and nitrogen purge inlet (sweep). Each of the reactions were heated to the time and temperature indicated in Table 3 below. Gel permeation chromatography (GPC) was performed on all polymer samples and solutions to determine weight average molecular weight and number average molecular weight as indicated in the Table 3 below. All solid polymers were collected by filtration in a Buchner funnel, air-dried, and then dried in vacuo at temperatures of about 40 to70°C. For one-pot preparation, the molten polymers were subsequently dissolved in solvents. The percent solutions were based on the theoretical yield. The synthesis involved in each individual example is discussed in detail below.

Example 55

Dimethyl 2,6-naphthalenedicarboxylate (24.33 grams, 99.63 mmol), dimethylterephthalate (19.44 grams, 100.1 mmol), ethylene glycol (7.63 grams, 123 mmol), glycerol (7.29 grams, 79.2 mmol), and para-toluene sulfonic acid (PTSA) (0.46 grams, 2.4 mmol) were charged to a reaction flask. Reaction conditions are shown in Table 3 below. The resultant polymer was dissolved in an amount of 10 wt% in a mixture of methyl-2-hydroxyisobutyrate (HBM), methyl 2-methoxyisobutyrate (MBM) and anisole, wherein the weight percents are based upon the total weight of the polymer as well as the weight of the HBM, MBM and anisole.

Example 56

Dimethyl 2,6-naphthalenedicarboxylate (30.5 grams, 125 mmol), dimethylterephthalate (14.5 grams, 74.7 mmol), ethylene glycol (7.20 grams, 116 mmol), glycerol (7.30 grams, 79.3 mmol) and PTSA (0.47 grams, 2.5 mmol)

were charged to a reaction flask. Reaction conditions are shown in Table 3 below. The resultant polymer was dissolved in an amount of 10 wt% in a mixture of tetrahydrofurfuryl alcohol and anisole wherein the weight percents are based upon the total weight of the polymer as well as the weight of the tetrahydrofurfuryl alcohol and anisole.

Example 57

Dimethyl 2,6-naphthalenedicarboxylate (47.70 grams, 195.3 mmol), dimethyl terephthalate (25.90 grams, 133.4 mmol), glycerol (32.90 grams, 357.2 mmol), PTSA (0.84 grams, 4.4 mmol), and anisole (36 grams) were charged to the reaction flask. Reaction conditions are shown in Table 3 below. The resultant polymer was dissolved in an amount of 10 wt% in a mixture of HBM and anisole wherein the weight percent is based upon the total weight of the polymer as well as the weight of the HBM and anisole.

Example 58

Dimethyl 2,6-naphthalenedicarboxylate (25.61 grams, 104.8 mmol), dimethyl terephtalate (13.58 grams, 69.93 mmol), glycerol (16.72 grams, 181.5 mmol), PTSA (0.45 grams, 2.4 mmol), and anisole (18.8 grams) were charged to the reaction flask. Reaction conditions are shown in Table 4 below. The resultant polymer was dissolved in tetrahydrofuran (THF) and precipitated in isopropanol (IPA) to obtain 36.9 grams of polymer with a yield of 83%. The resultant polymer was dissolved in an amount of 10 wt% in a mixture of HBM and anisole wherein the weight percent is based upon the total weight of the polymer as well as the weight of the HBM and anisole.

Table 4

| Example | Reaction Temperature (°C) | Reaction Time (hr) | $M_w$(RI) gm/mole | $M_n$(RI) gm/mole | Polydispersity |
|---|---|---|---|---|---|
| 55 | 150-200 | 4 | 4065 | 1782 | 2.28 |
| 56 | 160 | 15 | 8638 | 2318 | 3.72 |
| 57 | 150-160 | 5.5 | 1225 (UV) | 425 (UV) | 2.88 |
| 58 | 150-160 | 13 | 16459 | 3902 | 4.22 |

Examples 59-62

Each of the polymer solutions from Examples 55-58 (3.0 grams of solution containing 0.3 grams of polymer) is combined with the gold nanoparticles from Example 1 (0.093 grams), glycoluril, 1,3,4,6-tetrakis(methoxymethyl) (0.070 grams), p-toluenesulfonic acid (PTSA) solution (0.233 g 1% PTSA solution in a 30/40/30 w/w blend of propylene glycol methyl ether/cyclohexanone /2-hydroxybutyric acid methyl ester) and a 30/40/30 w/w blend of propylene glycol methyl ether/cyclohexanone/2-hydroxybutyric acid methyl ester (12.11 grams). The formulations are agitated overnight on a laboratory roller to dissolve the components, sonicated in an ultrasonic bath for 10 minutes and filtered through a 0.2 micrometer membrane filter. A test memory cell is fabricated by spin coating the formulation of the present example on a 100 mm diameter silicon wafer (p-type, 0.0001 - 0.1 Ω-cm) and baked on a hotplate at 120°C for 60 seconds to give a film thickness of about 20 - 100 nm, typically about 50 nm. Aluminum dots of about 0.5 mm in diameter and about 45 nm of thickness are then evaporated thermally on top of the film through a shadow mask at a pressure of about $10^{-6}$ to $5 \times 10^{-5}$ torr. Current-voltage characteristics are measured using a Keithley 6517A electrometer with the silicon wafer grounded and the aluminum electrode configured as the working electrode. The entire measurement is controlled by LabView software (National Instruments Corp.), programmed initially to sweep from 0.0 V to about 7.0 V, from a 7.0 V to 0.0 V, and from 0.0 to -7.0 V. The voltage range is then adjusted to avoid overdriving the cell during the positive and negative voltage sweeps.

Example 63

This example was undertaken to demonstrate the synthesis of $Co_4(\eta^5\text{-}C_5H_5)_4(\mu_3\text{-}Te)_4$ - a cyclopentadienyl cobalt tellurium metal cluster. $Co(\eta^5\text{-}C_5H_5)(CO)_2$ (2.0 grams, 11.1 mmol) was weighed into a 500 ml flask equipped with a magnetic stirring bar and stopcock side-arm. To this was added 250 ml of toluene and 200 mesh tellurium powder (5.0 grams, 39.2 mmol). The mixture was refluxed under argon with rapid stirring for 48 hours. Over the course of the reaction, the bright red-orange color of the solution gradually changed to a deep red-brown. The hot reaction mixture was immediately filtered through Whatman No. 2 filter paper using a filter transfer device having a 20-guage steel tube

with a tubular glass receptacle fastened to the end with epoxy glue - to which the filter paper was wired. Repeated washings of the leftover solid with 10 ml portions of hot toluene were performed followed by filtration, until the filtrate was colorless. The toluene washings were combined with the original filtered solution. To this crude product solution was added 50 ml of pentane. The resulting solution was cooled to a temperature of -15°C for several hours. From the cooled product solution was precipitated $Co_4(\eta^5\text{-}C_5H_5)_4(\mu_3\text{-}Te)_4$ as a black crystalline solid, hereinafter denoted as $[CpCoTe]_4$. This metal cluster system is an electron donor, capable of undergoing at least four oxidation steps to yield stable species having charges of 0, +1, +2, +3 and +4 respectively.

Example 64

This example was undertaken to demonstrate the synthesis of $Co_4(\eta^5\text{-}C_5(CH_3)_5(\mu_3\text{-}Te)_4$ - a pentamethylcyclopentadienyl cobalt tellurium metal cluster. The synthesis method of Example 64 is used except that $Co(\eta^5\text{-}C_5(CH_3)_5)(CO)_2$ (3.0 grams, 12.0 mmol) was reacted with the tellurium powder (200 mesh, 5.0 grams, 39.2 mmol) and the toluene solvent of the crude product solution was stripped under vacuum. The resulting solid $Co_4(\eta^5\text{-}C_5(CH_3)_5)_4(\mu_3\text{-}Te)_4$ was either used as such or redissolved in a minimum amount of hot toluene and placed in a freezer at a temperature of -15° C to yield black crystals of $Co_4(\eta^5\text{-}C_5(CH_3)_5)_4(\mu_3\text{-}Te)_4$, hereinafter denoted as $[PMCpCoTe]_4$. This metal cluster system is an electron donor, capable of undergoing at least three oxidation steps to yield stable species having charges of 0, +1, +2 and +3 respectively.

Example 65

In this example, the polymer of example 23 (15% w/w solution in PGMEA, 2.0 grams solution) was combined with $[CpCoTe]_4$ (0.075 grams) and a 50/50 w/w blend of methoxybenzene and 2-heptanone (12.93 grams). The formulation was agitated overnight on a laboratory roller to dissolve the components and filtered through a 0.2 micrometer membrane filter. A test memory cell using the formulation of this example was fabricated as in Example 25.

Example 66

The polymer of example 23 (15% w/w solution in PGMEA, 2.0 g solution) was combined with $[PMCpCoTe]_4$ (0.10 grams) and a 50/50 w/w blend of methoxybenzene and 2-heptanone (11.23 grams). The formulation was agitated overnight on a laboratory roller to dissolve the components and filtered through a 0.2 micrometer membrane filter. A test memory cell using the formulation of this example is fabricated as in Example 25.

Example 67

A 100 millimeter diameter silicon wafer with 100 nm of silica was coated with aluminum (about 1% w/w silicon, 45 nm of thickness, pressure: about $10^{-6}$ to $5 \times 10^{-5}$ torr). The wafer was baked on a hotplate at 200°C for 60 seconds following which a Shipley 1813 photoresist was applied. The wafer was again baked at 100° for 60 seconds. The coating thickness was 1.3 micrometers. The resist was exposed in a 1:1 projection printer and then developed to give nominal lines and spaces having a minimum feature dimension of 3 micrometers. The underlying aluminum was patterned by wet etching using a solution comprising 80wt% $H_3PO_4$, 5wt% $CH_3COOH$, 5wt% $HNO_3$ and10wt% $H_2O$. The etch was conducted at 40°C for 30 to 60 seconds. The remaining resist was then stripped away. The formulation from Example 29 was spin-coated, baked on a hotplate at 110°C for 60 seconds and baked a second time on a hotplate at 200°C for 60 seconds to give a polymeric film having a thickness of about 50 nm. An aluminum layer of about 45 nm thickness was coated on top of the polymeric film. A Shipley 1813 photoresist was applied and baked on a hotplate at 100°C for 60 seconds to give a coating of 1.3 micrometers. The resist was exposed to light in a 1:1 projection printer and developed to give lines and spaces having a minimum feature dimension of 3 micrometers, substantially perpendicular to those detailed above, baked on a hotplate at 120°C for 60 seconds and the underlying aluminum was patterned by wet etching using a formulation having 80wt% $H_3PO_4$,5wt% $CH_3COOH$, 5wt% $HNO_3$, and 10wt% $H_2O$. The etching was conducted at 40°C for a time period of 30 to 60 seconds. The remaining resist was stripped by flood exposure and development. Cross point array test patterns were successfully fabricated in this way.

Example 68

This example demonstrates the programming of a field programmable film, wherein at least one of the electrodes is not in a fixed position relative to the film. The formulation from Example 25 was spin coated on a p-type silicon wafer having a resistivity of about 0.01 ohm-cm and baked at 100°C for 60 seconds and baked a second time at 200°C for 60 seconds. A coupon of about $0.5 \times 0.5\ cm^2$ is cleaved from the coated wafer, mounted polymer side up on a magnetic

substrate with a bit of silver paste and placed in a Digital Instruments Multimode 3A scanning probe microscope, equipped with a titanium-coated tip, a voltage source capable of applying a DC bias voltage to the tip and a picoammeter for measuring current through the tip when the voltage was applied. The tip was rastered across the field programmable film in contact mode with a 10 V bias in such a way as to create a rectangular pattern of about 3 μm by about 10 μm in the field programmable film. The field programmable film was read by applying a bias voltage of 4 V and sweeping a rectangular raster pattern of about 3 μm by about 10 μm in a perpendicular direction to the original rectangular pattern while monitoring the current. The areas that had previously been subjected to an electric field typically show a higher current by a factor of more than 10 than those areas that were not previously subjected to an electric field. Alternatively, the field programmable film was programmed point-wise by tapping the tip having either a 10 V bias voltage or a 0 V bias voltage on the surface of the film and then moving the tip relative to the film. Reading the point-wise programmed film was accomplished by measuring a current at the location where the bias voltage may or may not have been applied. In either case, a negative bias voltage was applied to the previously written film at about-5 to about-10 V to erase the programming.

Example 69

A test memory cell is prepared as follows: A 10% solution of a silsesquioxane binder polymer, randomly substituted with phenyl, methyl, and dimethyl siloxane groups at a composition of about 41, 56 and 3 mole % based on the feed stream of phenyl triethoxy silane, methyl triethoxy silane and dimethyl diethoxy silane (sold under the trade name GR150F from Technoglass corporation) in a solvent having about equal portions w/w of dimethyl glutarate, dimethyl succinate and dimethyl adipate (hereinunder referred to as DBE), 92 g, is blended with a 43% w/w suspension ofCuO nanoparticles of size about 29 nm (sold as U 1102DBE by the Nanophase Corporation) in DBE solvent, 4.0 g, and a 50.7% suspension of Antimony Tin Oxide nanoparticles of size about 30 nm, wherein the Sb/Sn mole ratio is about 1.9 (sold as SI222DBE by the Nanophase Corporation) in DBE solvent, 4.0 g. The resulting blend is rolled in a bottle overnight on a laboratory roller and filtered through a polyethylene filter membrane having pore sizes of about 200 nm. The resulting mixture is spin-coated on a 100 mm silicon wafer having a resistivity of about 0.001 - 1.0 ohm-cm at a spin speed of about 500 - 5000 rpm to give a thickness of about 100 nm. The coated wafer is first baked on a hotplate at 120° C for 60 sec and then transferred to a second hotplate and baked at 200° C for 60 seconds. Aluminum pads of diameter 0.2 mm are evaporated onto the coated wafer and the material is mounted on a probe station and tested as described supra.

Example 70

The test memory cell of Example 69 is fabricated except that the binder polymer is hydridosilsesquioxane having an approximate empirical formula of $HSiO_{1.5}$.

Examples 71-81

The test memory cell of Example 69 is fabricated except that the formulations components are in %w/w amounts as given below:

| | Polymer Binder, %w/w | CuO nanoparticles %w/w (Ex. 93-103) | SbSnO Nanoparticles, %w/w (Ex. 82-82) |
|---|---|---|---|
| Example 71 | 85 | 10 | 5 |
| Example 72 | 98 | 1 | 1 |
| Example 73 | 85 | 5 | 10 |
| Example 74 | 85 | 7.5 | 7.5 |
| Example 75 | 89 | 1 | 10 |
| Example 76 | 89 | 10 | 1 |
| Example 77 | 87 | 10 | 3 |
| Example 78 | 87 | 3 | 10 |
| Example 79 | 89.2 | 5.4 | 5.4 |
| Example 80 | 93.5 | 5.5 | 1 |
| Example 81 | 93.5 | 1 | 5.5 |

Examples 82-92

The test memory cell of Examples 71-81 is fabricated and tested except that the antimony tin oxide nanoparticle suspension is replaced by a similar suspension of indium tin oxide in DBE.

Examples 93-103

The test memory cell of Examples 1-81 is fabricated and tested except that the copper oxide nanoparticle suspension is replaced by a similar suspension of nonstoichiometric copper sulfide in DBE.

Comparative Example 104

In this example, polymethylmethacrylate was mixed with gold particles. 0.3 grams of polymethylmethacrylate having a weight average molecular weight of 254,000 grams/mole and a polydispersity index of less than or equal to about 1.1 was combined with the gold nanoparticles from Example 1 (0.1 grams), 8-hydroxyquinoline (0.1 grams) and o-dichlorobeazene (16.17 grams). The gold particles were not covalently bonded to the polymethylmethacrylate. The 8-hydroxyquinoline was also not bonded to the polymethylmethacrylate. The mixture was agitated overnight on a laboratory roller to dissolve the components, sonicated in an ultrasonic bath for about 10 minutes and filtered through a 0.2 micrometer membrane filter. A test memory cell using the formulation of this example was fabricated and tested as in Example 25 except that the polymer film is baked on a hotplate at 80°C for 30 minutes. Working cells are obtained with parameters similar to those of example 25.

Comparative Example 105

The formulation of Example 104 was used to fabricate a test memory cell as in Example 25. No working cells were obtained, presumably because most of the 8-hydroxyquinoline was evaporated from the film during the bake step.

Comparative Example 106

A 100 mm diameter silicon wafer with 100 nm of silica was coated with aluminum (about 1% w/w silicon, 45 nm of thickness, and pressure of about $10^{-6}$ to $5 \times 10^{-5}$ torr). The wafer was baked on a hotplate at 200°C for 60 seconds and Shipley 1813 photoresist was applied and baked at 100°C for 60 seconds to give a coating of 1.3 micrometers. The resist was exposed in a 1:1 projection printer and developed to give nominal lines and spaces having a minimum feature dimension of 3 micrometers and the underlying aluminum was patterned by wet etching using standard etch chemistry. The remaining resist is stripped. The formulation from Example 56 was first spin-coated and then baked on a hotplate at 80°C for 30 minutes to give a polymer-based film of about 50 nm of thickness. Aluminum having a thickness of about 45 nm was coated on top of the polymer-based film. Shipley 1813 photoresist was applied and baked on a hotplate at 100°C for 60 seconds to give a coating of 1.3 micrometers. The resist was exposed in a 1:1 projection printer and developed to give lines and spaces having a minimum dimensions of 3 micrometers, substantially perpendicular to those detailed above and then baked on a hotplate at 120° C for 60 seconds. After the last bake step, significant bubbling under the aluminum lines was observed. This bubbling appears to originate from the outgassing of the above polymer-based film and creates enough defects that successful fabrication of testable, working cell appears to be difficult.

## Claims

1. An electronic memory, switching or data storage device comprising an electric field programmable film, **characterized in that** said film comprises:

    (a) an electron donor and a polymer bonded to an electroactive moiety, wherein the electroactive moiety is an electron acceptor; and/or
    (b) an electron acceptor and a polymer bonded to an electroactive moiety, wherein the electroactive moiety is an electron donor.

2. The device of Claim 1, wherein the electron donor and electron acceptor form a donor-acceptor complex.

3. The device of Claim 1, wherein the electroactive moiety is a pyrene, a naphthalene, an anthracene, a phenanthrene, a tetracene, a pentacene, a triphenylene, a triptycene, a fluorenone, a phthalocyanine, a tetrabenzoporphine, a 2-amino-1H-imidazole-4,5-dicarbonitrile, a carbazole, a ferrocene, a dibenzochalcophene, a phenothiazine, a tetrathiafulvalene, a bisaryl azo group, a coumarin, an acridine, a phenazine, a quinoline, an isoquinoline, a pentafluoroaniline, an anthraquinone, a tetracyanoanthraquinodimethane, a tetracyanoquinodimethane, or a combination comprising at least one of the foregoing electroactive moieties.

**4.** The device of Claim 1, wherein the electroactive moiety is a functional group, molecule, nanoparticle or particle.

**5.** The device of Claim 1, wherein the electroactive moiety is a nanoparticle comprising metals, metal oxides, metalloid atoms, semiconductor atoms, or a combination comprising at least one of the foregoing.

**6.** The device of Claim 1, wherein the polymer has a dielectric constant of 2 to 1000.

**7.** The device of Claim 1 or 2, wherein the polymer is a polyacetal, a poly(meth)acrylic or polyacrylic, a polycarbonate, a polystyrene, a polyester, a polyamide, a polyamideimide, a polyolefin, a polyarylate, a polyarylsulfone, a polyethersulfone, a polyphenylene sulfide, a poiysulfone, a polyimide, a polyetherimide, a polytetrafluoroethylene, a polybenzocyclobutene, a polyetherketone, a polyether etherketone, a polyether ketone ketone, a polybenzoxazole, a polyoxadiazole, a polybenzothiazinophenothiazine, a polybenzothiazole, a potypyrazinoquinoxaline, a polypyromellitimide, a polyquinoxaline, a polybenzimidazole, a polyoxindole, a polyoxoisoindoline, a polydioxoisoindoline, a polytriazine, a polypyridazine, a polypiperazine, a polypyridine, a polypiperidine, a polytriazole, a polypyrazole, a polycarborane, a polyoxabicyclononane, a polydibenzofuran, a polyphthatide, a polyacetal, a polyanhydride, a polyvinyl ether, a polyvinyl thioether, a polyvinyl alcohol, a polyvinyl ketone, a polyvinyl halide, a polyvinyl nitrile, a polyvinyl ester, a polysulfonate, a polysulfide, a polythioester, a polysulfone, a polysulfonamide, a polyurea, a polyphosphazene, a polysilazane, a polysiloxane, or a combination comprising at least one of the foregoing polymers.

**8.** The device of Claim 1, wherein the polymer is crosslinked.

**9.** The device of any one of Claims 1 to 8, wherein an electrode is in electrical contact with the electric field programmable film and the electrode position is fixed relative to the electric field programmable film or the electrode can change its position relative to the electric field programmable film.

**10.** A data processing machine comprising:

a processor for executing an instruction; and
a device as claimed in any one of claims 1-9.

## Patentansprüche

**1.** Elektronische Speicher-, Schalt- oder Datenspeichervorrichtung, umfassend eine Folie, die durch ein elektrisches Feld programmierbar ist, **dadurch gekennzeichnet, daß** die Folie:

(a) einen Elektronendonor und ein Polymer, das an eine elektroaktive Einheit gebunden ist, wobei die elektroaktive Einheit ein Elektronenakzeptor ist, und/oder
(b) einen Elektronenakzeptor und ein Polymer, das an eine elektroaktive Einheit gebunden ist, wobei die elektroaktive Einheit ein Elektronendonor ist, umfaßt.

**2.** Vorrichtung nach Anspruch 1, wobei der Elektronendonor und Elektronenakzeptor einen Donor-Akzeptor-Komplex bilden.

**3.** Vorrichtung nach Anspruch 1, wobei die elektroaktive Einheit ein Pyren, ein Naphthalin, ein Anthracen, ein Phenanthren, ein Tetracen, ein Pentacen, ein Triphenylen, ein Triptycen, ein Fluorenon, ein Phthalocyanin, ein Tetrabenzoporphin, ein 2-Amino-1 H-imidazol-4,5-dicarbonitril, ein Carbazol, ein Ferrocen, ein Dibenzochalcophen, ein Phenothiazin, ein Tetrathiafulvalen, eine Bisarylazogruppe, ein Cumarin, ein Acridin, ein Phenazin, ein Chinolin, ein Isochinolin, ein Pentafluoranilin, ein Anthrachinon, ein Tetracyanoanthrachinodimethan, ein Tetracyanochinodimethan oder eine Kombination, umfassend mindestens eine der vorstehenden elektroaktiven Einheiten, ist.

**4.** Vorrichtung nach Anspruch 1, wobei die elektroaktive Einheit eine funktionelle Gruppe, ein Molekül, ein Nanoteilchen oder ein Teilchen ist.

5. Vorrichtung nach Anspruch 1, wobei die elektroaktive Einheit ein Nanoteilchen ist, umfassend Metalle, Metalloxide, Metalloidatome, Halbleiteratome oder eine Kombination, umfassend mindestens eine der vorherstehenden, ist.

6. Vorrichtung nach Anspruch 1, wobei das Polymer eine Dielektrizitätskonstante von 2 bis 1000 aufweist.

7. Vorrichtung nach Anspruch 1 oder 2, wobei das Polymer ein Polyacetal-, ein Poly(meth)acryl- oder ein Polyacrylpolymer, ein Polycarbonat, ein Polystyrol, ein Polyester, ein Polyamid, ein Polyamidimid, ein Polyolefin, ein Polyarylat, ein Polyarylsulfon, ein Polyethersulfon, ein Polyphenylensulfid, ein Polysulfon, ein Polyimid, ein Polyetherimid, ein Polytetrafluorethylen, ein Polybenzocyclobuten, ein Polyetherketon, ein Polyetheretherketon, ein Polyetherketonketon, ein Polybenzoxazol, ein Polyoxadiazol, ein Polybenzothiazinphenothiazin, ein Polybenzothiazol, ein Polypyrazinchinoxalin, ein Polypyromellitimid, ein Polychinoxalin, ein Polybenzimidazol, ein Polyoxindol, ein Polyoxoisoindolin, ein Polydioxoisoindolin, ein Polytriazin, ein Polypyridazin, ein Polypiperazin, ein Polypyridin, ein Polypiperidin, ein Polytriazol, ein Polypyrazol, ein Polycarboran, ein Polyoxabicyclononan, ein Polydibenzofuran, ein Polyphthalid, ein Polyacetal, ein Polyanhydrid, ein Polyvinylether, ein Polyvinylthioether, ein Polyvinylalkohol, ein Polyvinylketon, ein Polyvinylhalogenid, ein Polyvinylnitril, ein Polyvinylester, ein Polysulfonat, ein Polysulfid, ein Polythioester, ein Polysulfon, ein Polysulfonamid, ein Polyharnstoff, ein Polyphosphazen, ein Polysilazan, ein Polysiloxan oder eine Kombination, umfassend mindestens eines der vorstehenden Polymere, ist.

8. Vorrichtung nach Anspruch 1, wobei das Polymer vernetzt ist.

9. Vorrichtung nach einem der Ansprüche 1 bis 8, wobei eine Elektrode in elektrischem Kontakt mit der Folie, die durch ein elektrisches Feld programmierbar ist, steht und die Elektrodenposition relativ zu der Folie, die durch ein elektrisches Feld programmierbar ist, fixiert ist oder die Elektrode deren Position relativ zu der Folie, die durch ein elektrisches Feld programmierbar ist, ändern kann.

10. Datenverarbeitungsvorrichtung, umfassend:

einen Prozessor zum Ausführen einer Anweisung und
eine Vorrichtung, wie in einem der Ansprüche 1 bis 9 beansprucht.

## Revendications

1. Dispositif de mémoire électronique, de commutation ou de stockage de données comprenant un film programmable par champ électrique, **caractérisé en ce que** ledit film comprend :

(a) un donneur d'électrons et un polymère lié à une moitié électro-active, dans lequel la moitié électro-active est un accepteur d'électrons ; et/ou
(b) un accepteur d'électrons et un polymère lié à une moitié électro-active, dans lequel la moitié électro-active est un donneur d'électrons.

2. Dispositif selon la revendication 1, dans lequel le donneur d'électrons et l'accepteur d'électrons forment un complexe donneur-accepteur.

3. Dispositif selon la revendication 1, dans lequel la moitié électro-active est un pyrène, un naphtalène, un anthracène, un phénanthrène, un tétracène, un pentacène, un triphénylène, un triptycène, un fluorénone, une phtalocyanine, une tétrabenzoporphine, un 2-amino-1H-imidazole-4,5-dicarbonitrile, un carbazole, un ferrocène, un dibenzochalcophène, un phénothiazine, un tétrathiafulvalène, un groupe bisaryle azo, une coumarine, une acrydine, une phénazine, une quinoline, une isoquinoline, une pentafluoroaniline, une anthraquinone, un tétracyanoanthraquinodiméthane, un tétracyanoquinodiméthane ou une combinaison comprenant au moins l'une des moitiés électro-actives mentionnées ci avant.

4. Dispositif selon la revendication 1, dans lequel la moitié électro-active est un groupe fonctionnel, une molécule, une nanoparticule ou une particule.

5. Dispositif selon la revendication 1, dans lequel la moitié électro-active est une nanoparticule comprenant des métaux, des oxydes métalliques, des atomes de métalloïdes, des atomes de semiconducteurs ou une combinaison comprenant au moins l'un des éléments mentionnés ci avant.

**6.** Dispositif selon la revendication 1, dans lequel le polymère présente une constante diélectrique de 2 à 1000.

**7.** Dispositif selon la revendication 1 ou 2, dans lequel le polymère est un polyacétal, un poly(méth)acrylique ou polyacrylique, un polycarbonate, un polystyrène, un polyester, un polyamide, un polyamideimide, une polyoléfine, un polyacrylate, un polyarylsulfone, un polyéthersulfone, un sulfure de polyphénylène, un polysulfone, un polyimide, un polyétherimide, un polytétrafluoréthylène, un polybenzocyclobutène, un polyéthercétone, un polyétheréthercétone, un polyéthercétonecétone, un polybenzoxazole, un polyoxadiazole, un polybenzothiazinophénothiazine, un polybenzothiazole, un polypyrazinoquinoxaline, un polypyromellitimide, une polyquinoxaline, un polybenzimidazole, un polyoxindole, une polyoxoisoindoline, une polydioxoisoindoline, une polytriazine, une polypyridazine, une polypipérazine, une polypyridine, une polypipéridine, un polytriazole, un polypyrazole, un polycarborane, un polyoxabicyclononane, un polydibenzofurane, un polyphtatide, un polyacétal, un polyanhydride, un polyvinyléther, un polyvinylthioéther, un polyvinylalcool, un polyvinylcétone, un polyvinylhalure, un polyvinylnitrile, un polyvinylester, un polysulfonate, un polysulfure, un polythioester, un polysulfone, un polysulfonamide, une polyurée, un polyphosphazène, un polysilazane, un polysiloxane ou une combinaison comprenant au moins l'un des polymères mentionnés ci avant.

**8.** Dispositif selon la revendication 1, dans lequel le polymère est réticulé.

**9.** Dispositif selon l'une quelconque des revendications 1 à 8, dans lequel une électrode est en contact électrique avec le film programmable par champ électrique et la position d'électrode est fixée par rapport au film programmable par champ électrique ou l'électrode peut avoir sa position modifiée par rapport au film programmable par champ électrique.

**10.** Machine de traitement de données comprenant :

un processeur pour exécuter une instruction ; et
un dispositif tel que revendiqué selon l'une quelconque des revendications 1-9.

FIG. 1

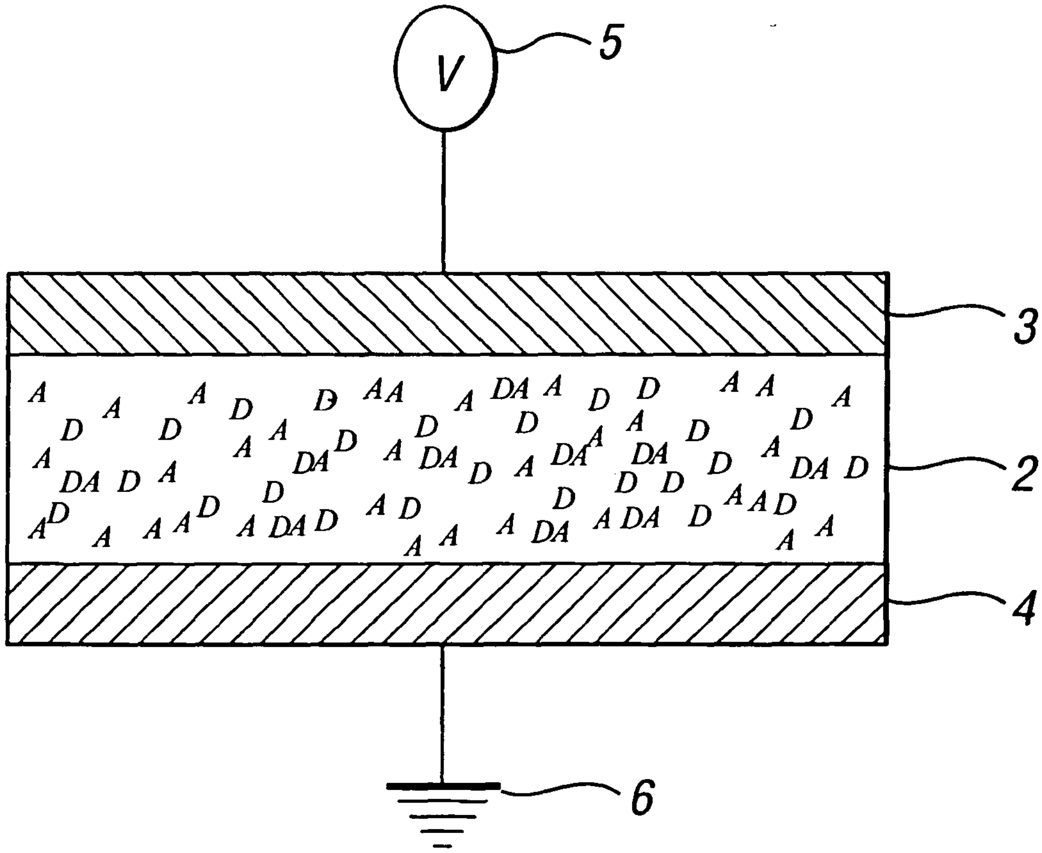

FIG. 2(a)

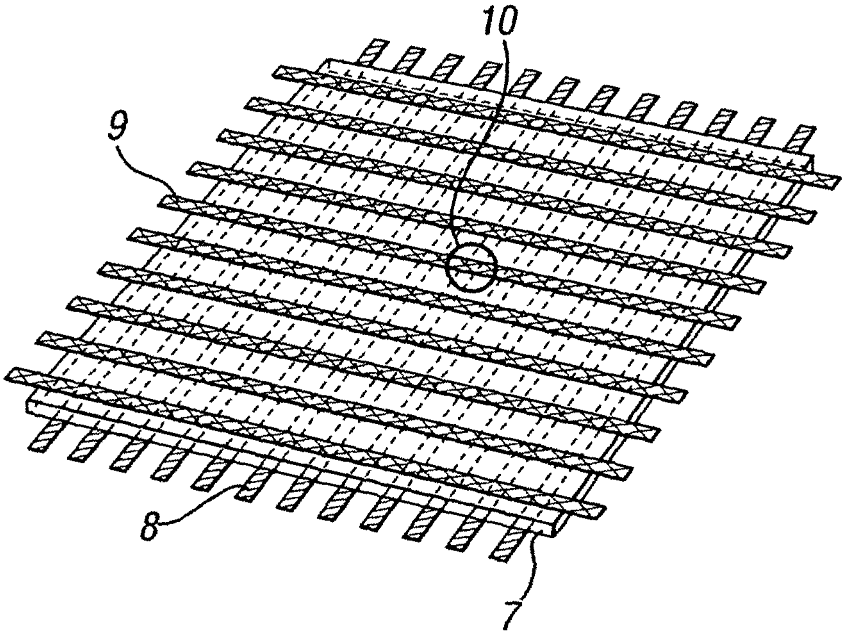


FIG. 2(b)

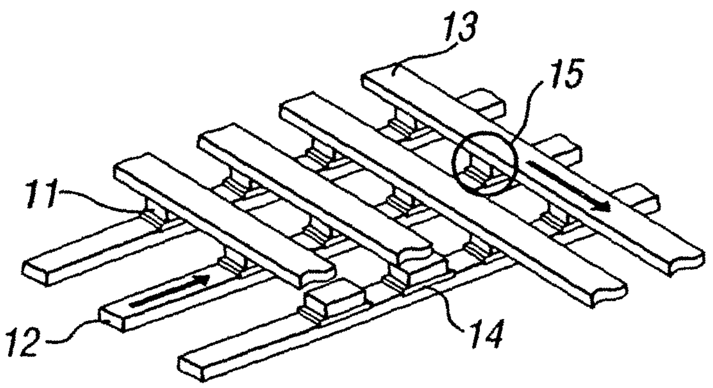

FIG. 3(a)

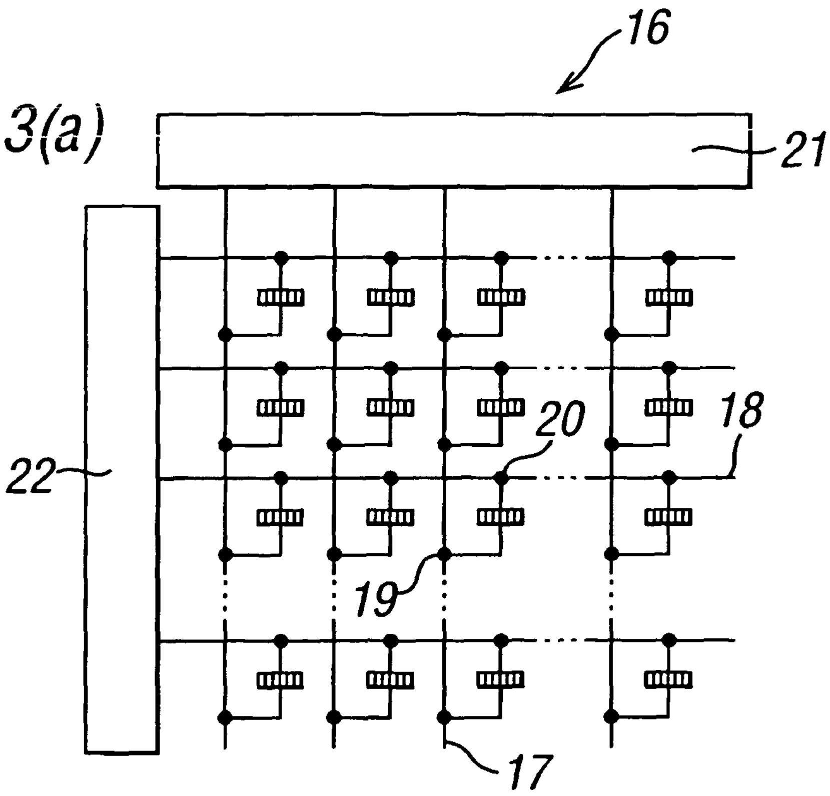


FIG. 3(b)

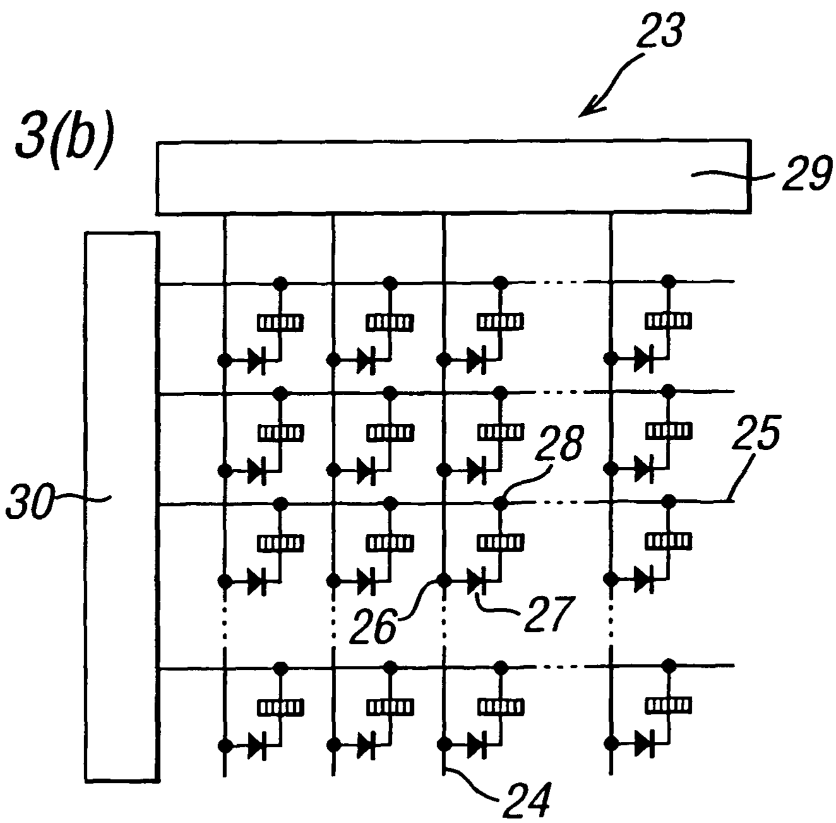

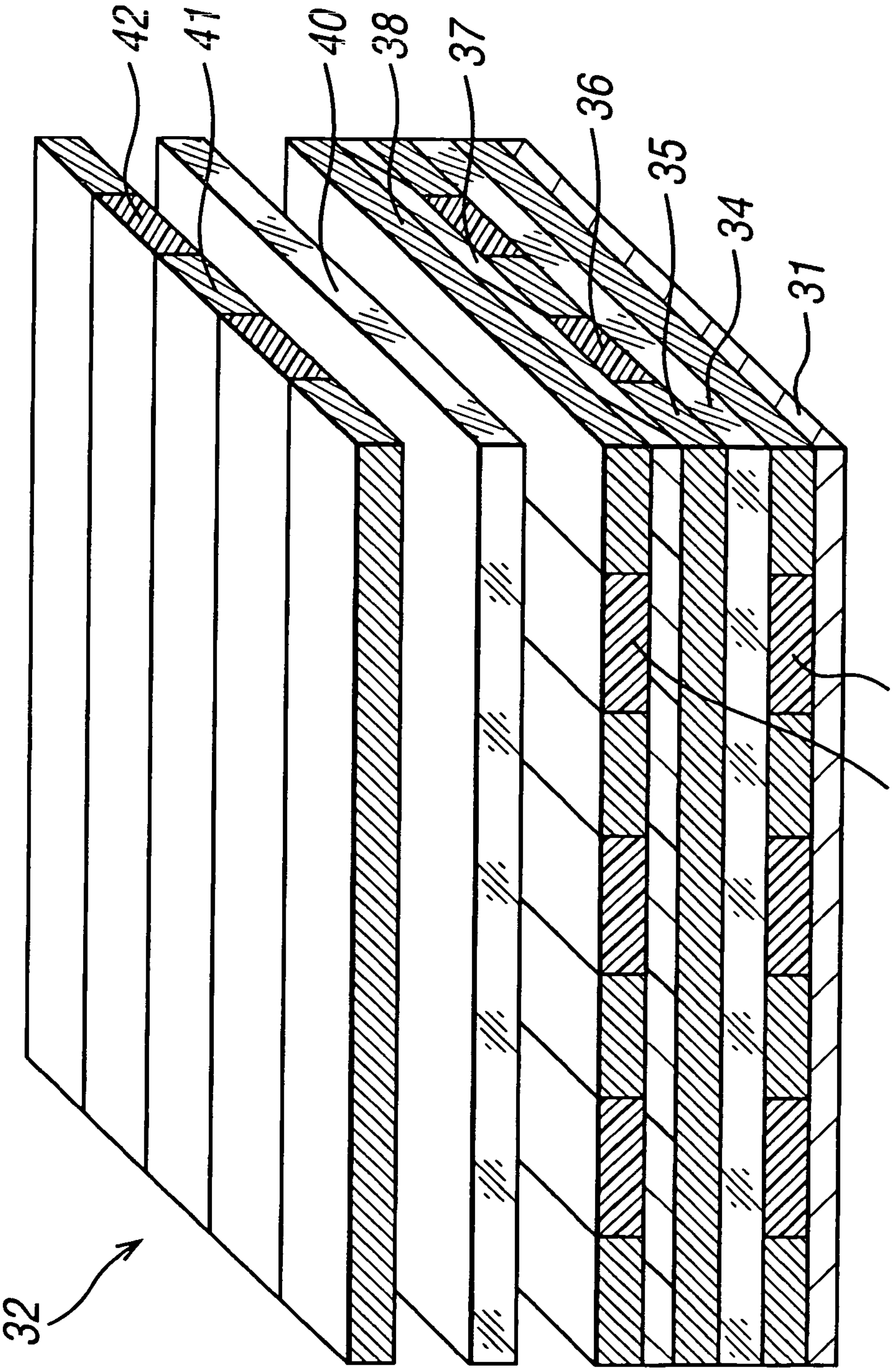


FIG. 4

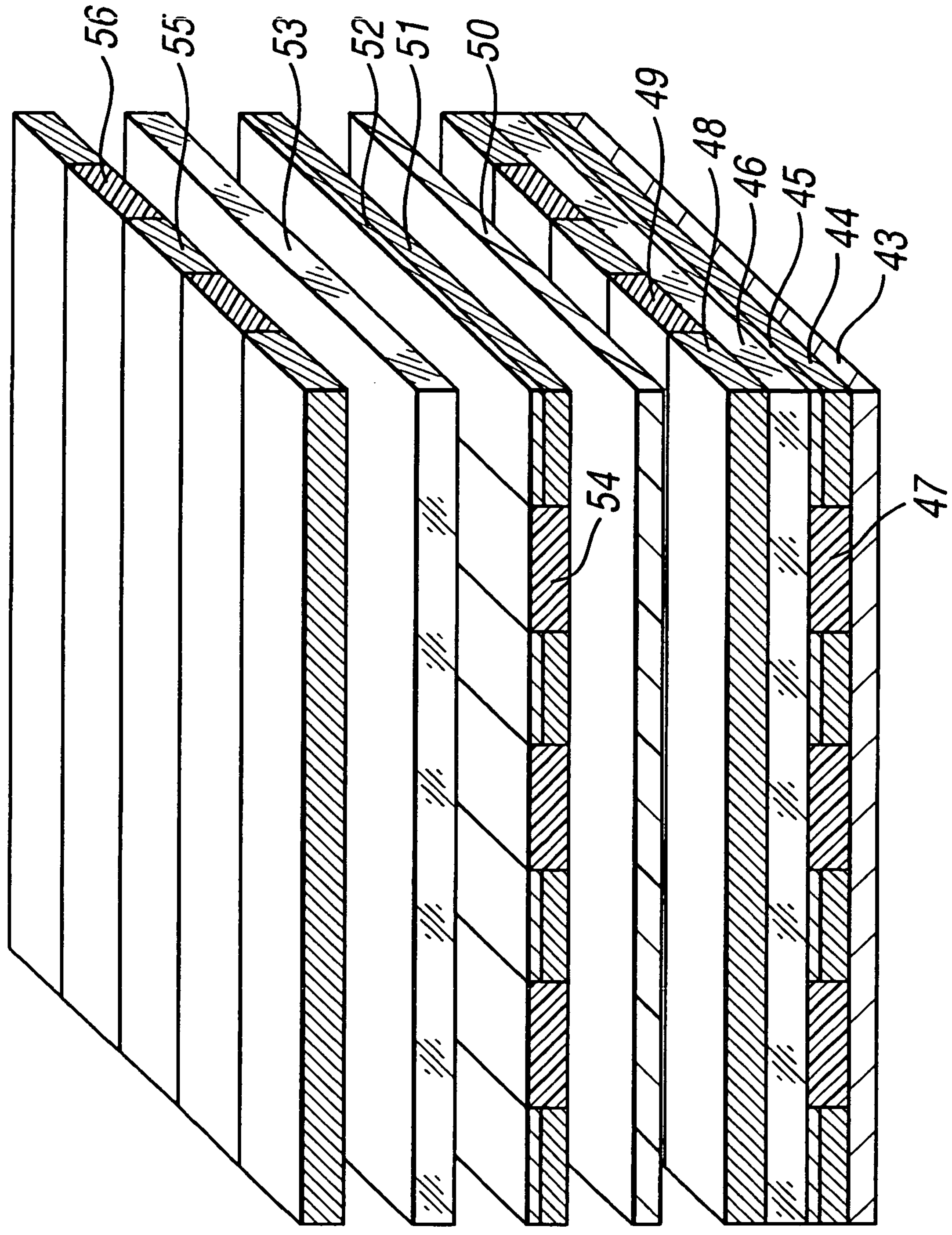


FIG. 5

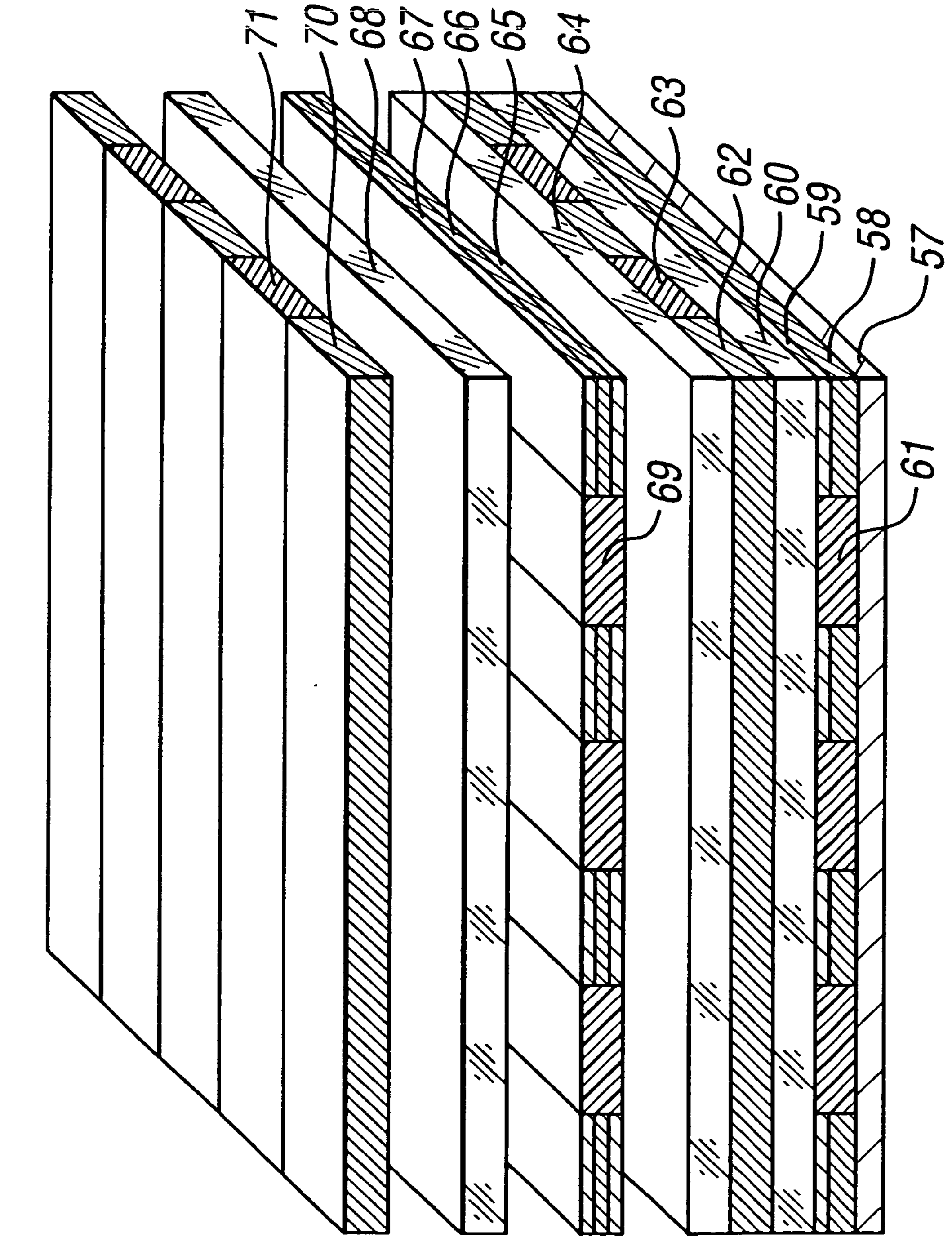


FIG. 6

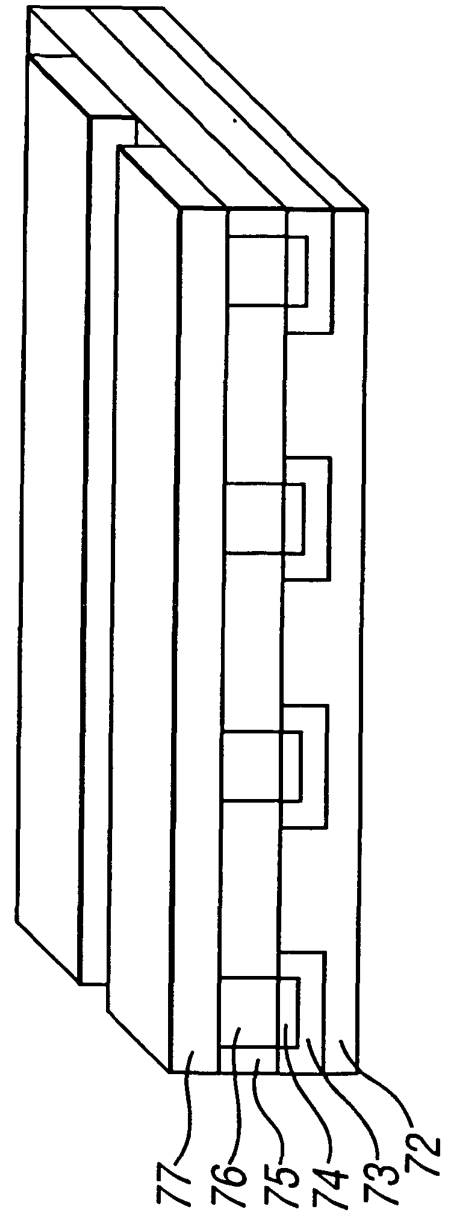


FIG. 7a

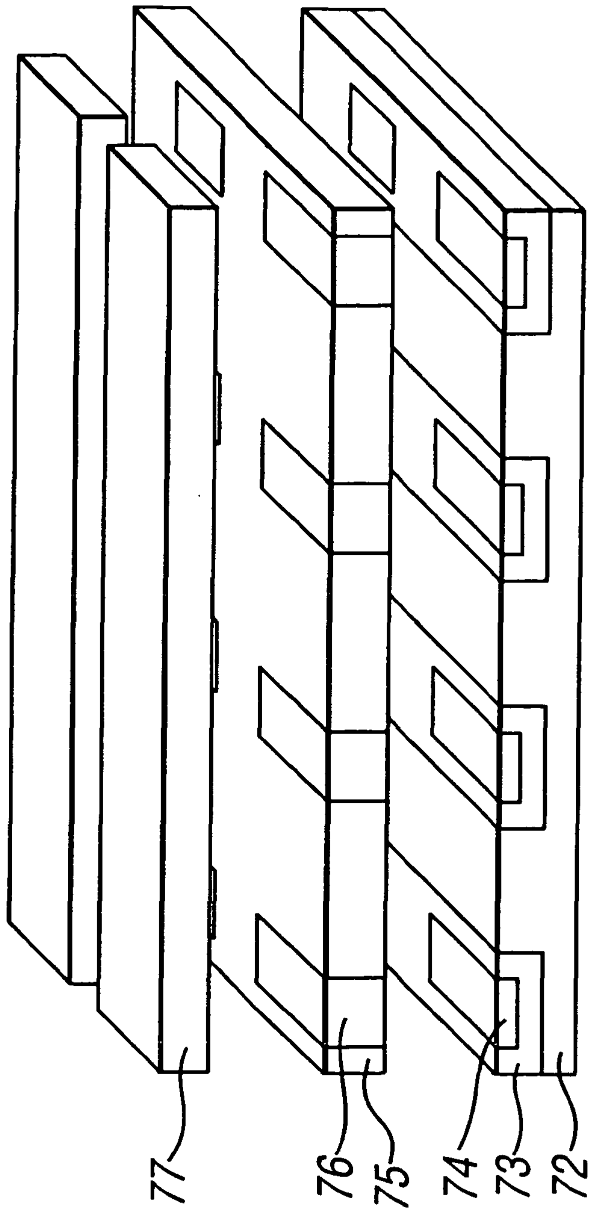


FIG. 7b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 02077986 A

### Non-patent literature cited in the description

- **G. MOORE.** *Electronics,* 1970, vol. 28, 56